(19) Europäisches Patentamt
European Patent Office
Office européen des brevets

(11) **EP 1 420 520 B1**

(12) **EUROPEAN PATENT SPECIFICATION**

(45) Date of publication and mention
of the grant of the patent:
**09.12.2009 Bulletin 2009/50**

(51) Int Cl.:
*H04B 1/707* (2006.01)

(21) Application number: **03027042.5**

(22) Date of filing: **25.08.1995**

(54) **Despreading of a CPM (continuous phase modulation) spread-spectrum signal**

Entspreizen eines CPM (continuous phase modulation) Spreizspektrumsignals

Desétalement d'un signal à spectre étalé MPC (modulation à phase continue)

(84) Designated Contracting States:
**AT BE CH DE DK ES FR GB GR IE IT LI LU MC NL PT SE**

(30) Priority: **09.09.1994 US 304091**
**07.06.1995 US 484007**
**07.06.1995 US 481613**
**07.06.1995 US 486827**
**07.06.1995 US 476461**
**07.06.1995 US 480668**
**07.06.1995 US 486824**
**07.06.1995 US 480914**
**07.06.1995 US 480167**
**07.06.1995 US 486883**
**07.06.1995 US 480442**
**07.06.1995 US 480903**
**07.06.1995 US 480443**
**07.06.1995 US 485638**
**07.06.1995 US 477480**

(43) Date of publication of application:
**19.05.2004 Bulletin 2004/21**

(62) Document number(s) of the earlier application(s) in accordance with Art. 76 EPC:
**95932334.6 / 0 806 079**

(73) Proprietor: **XIRCOM Wireless, Inc.**
**Colorado Springs,**
**Colorado 80907 (US)**

(72) Inventors:
• **Durrant, Randolph L.**
**Colorado Springs**
**CO 80920 (US)**
• **Burbach, Mark T.**
**Peyton**
**CO 80831 (US)**
• **Hoyt, Eugene P.**
**Colorado Springs**
**CO 80921 (US)**

(74) Representative: **Leeming, John Gerard**
**J.A. Kemp & Co.**
**14 South Square**
**Gray's Inn**
**London WC1R 5JJ (GB)**

(56) References cited:
**EP-A- 0 366 086      US-A- 5 151 920**
**US-A- 5 276 705**

**Description**

The field of this invention relates to spread spectrum communication and, more particularly, to transmitting and receiving continuous phase modulated (CPM) signals such as spread spectrum signals.

Spread spectrum is a type of signal modulation that spreads a signal to be transmitted over a bandwidth that substantially exceeds the data-transfer rate, hence the term "spread spectrum". In direct sequence spread spectrum, a data signal is modulated with a pseudo-random chip sequence; the encoded spread spectrum signal is transmitted to the receiver which despreads the signal. Several techniques are available for the transmitter to modulate the data signal, including biphase shift keying (BPSK) and continuous phase modulated (CPM) techniques. Minimum shift keying (MSK) is a known variation of CPM.

In despreading a spread spectrum signal, the receiver produces a correlation pulse in response to the received spread spectrum signal when the received spread spectrum signal matches the chip sequence to a predetermined degree. Various techniques are available for correlating the received signal with the chip sequence, including those using surface acoustic wave (SAW) correlators, tapped delay line (TDL) correlators, serial correlators, and others.

In spread spectrum communication CPM techniques are often chosen so as to preserve signal bandwidth of the spread spectrum signal when it is amplified and transmitted. Using CPM techniques also has the advantage that "class C" amplifiers may be used for transmitting the spread spectrum-signal. However, spread spectrum signals transmitted using CPM are difficult to decode with many types of spread spectrum correlators, including various SAW correlators and serial correlators. These types of correlators usually require a BPSK spread spectrum signal for effective correlation rather than an MSK or other CPM spread spectrum signal because a BPSK signal has either a zero or 180 degree phase shift for each chip time. Thus, each chip of a received BPSK signal may be compared with each chip of the spread spectrum code, and a maximum correlation pulse may be generated when a predetermined number of matches occur. However, when a CPM signal with the same data signal and chip rate is applied to the same correlator, the correlation pulse will generally be very weak and may be quite difficult to detect.

Another problem often encountered in attempting to correlate spread spectrum signals transmitted using CPM techniques is the absence of a coherent reference signal in the receiver. A coherent reference signal in this sense may be defined as a locally generated signal that matches the transmitter carrier signal in frequency and phase. The receiver may use the locally generated reference signal to demodulate the received signal. In practice, however, it can be difficult to independently generate a local reference signal in the receiver precisely matching the transmitted carrier signal in frequency and phase. Rather, a local reference signal generated in the receiver will usually be of a non-coherent variety that is, having small differences in frequency and phase from the transmitter's carrier signal. These frequency and phase differences are not constant but vary over time when an attempt is made to demodulate a received signal using a non-coherent reference signal, errors in correlation may occur due to mismatches in timing and variations in perceived amplitude caused by the frequency and phase differences.

Various methods for dealing with the above problem exist in which a coherent reference signal is created in the receiver by continuously measuring the frequency and phase differences between the received signal and a locally generated non-coherent reference signal, and then adjusting the non-coherent reference signal until it matches the frequency and phase of the received signal. Such methods, however, generally require the use of relatively complex feedback techniques and involve extra hardware. Moreover, locking on to the received frequency and phase can take an unacceptably large amount of time, particularly in systems where time is of the essence, such as in certain time division multiple access (TDMA) systems in which only a relatively brief time slot is allocated for periodic communication between a transmitter and receiver.

A particular non-coherent digital matched filter is described in A. Baier and P.W. Baier, "Digital Matched Filtering of Arbitrary Spread-Spectrum Waveforms Using Correlators with Binary Quantization," 2 Proceedings, 1983 IEEE Military Communications Conference, Vol. 2, pp. 418-423 (1983). The digital filter described therein uses four real filter channels to perform four-phase quantization in the complex plane, with the four quadrants being the quantization regions, and the result taking on the four complex values of $\pm 1 \pm j$. In the described four-phase filter, an input signal is divided into an in-phase signal and a quadrature signal. The in-phase signal and the quadrature signal are separately filtered, sampled and digitized using 1-bit quantization. The quantized in-phase signal and the quantized quadrature signal are each fed into two binary correlators each programmed with a reference sequence of N chips, one chip for each sample. The outputs of the four binary correlators are combined to produce a resultant output signal. Baier's four-phase digital matched filter is also described in A. Baier, "A Low-Cost Digital Matched Filter for Arbitrary Constant-Envelope Spread Spectrum Waveforms," IEEE Transactions on Communications, Vol. Com-32, No. 4, April 1984, pp. 354-361.

These references suggest that for demodulation of non-coherent CPM signals such as QPSK, MSK, OQPSK, and GMSK signals, four real channels are needed to fully recover the transmitted signal. Further, the described four-phase filter shows only a system using 1-bit quantization, and does not describe a technique for serial correlation.

Accordingly, it would be advantageous to provide a method of modulation and demodulation particularly suited to CPM signals. It would further be advantageous to provide a method of CPM modulation and demodulation that does not require the generation of a coherent reference signal, that is capable of rapid correlation, and that may be used with analog correlators and digital correlators in an effective manner. It would further be advantageous to provide a flexible and effective system for CPM modulation and demodulation that does not require a coherent reference signal, and that is suitable for use in an environment of cellular communications.

US-A-5151920 discloses a system in which data symbols and non-data symbols are transmitted to a radio LAN station via a spread spectrum signal. The data symbols and the non-data symbols are spread via first and second spreading codes, respectively. The receiving radio LAN station includes first and second correlators which respectively correlate the received spread spectrum signal against the first spreading code to retrieve the data symbols and against the second spreading code to retrieve the non-data symbols. Rectangular representations of the received data and non-data symbols are thus produced and are converted to polar form via appropriate rectangular to polar converters.

EP-A-0366086 discloses a code shift keying communication method and apparatus on the signal transmitting side in which two Manchester M series equal in code length are produced with a predetermined period. The Manchester M series to actually be transmitted has a maximum value of the absolute value of its autocorrelation which is always larger than that of the cross-correlation of the two Manchester M series. In every predetermined period, one of the two series is selected; the selection depends on whether the transmitting data is "1" or "0", so that the selected series is transmitted as a transmitting signal. On the signal receiving side, a receiving signal is compared with each of two Manchester M series which are the same as those on the signal transmitting side, to provide two correlation outputs. The correlation outputs are subjected to comparison, and the receiving data "0" or "1" is selected according to the result of comparison.

The invention, which is defined in the appended claims, relates to a method and apparatus for despreading CPM spread spectrum signals in accordance with claims 1 and 5 respectively.

The present invention will be described below with reference to an exemplary embodiment and the accompanying drawings, in which:

Figure 1 is a block diagram of a spread spectrum communication transmitter and receiver as known in the art.
Figure 2 depicts a pattern of cells for use in spread spectrum communication.
Figure 3 is a graph of phase changes over time for an MSK signal.
Figures 4A-4C are a set of graphs showing a relationship among phase components.
Figure 5A is a block diagram showing means for generating a CPM spread spectrum signal.
Figure 5B is a graph of I and Q values.
Figure 6 is a block diagram of a spread spectrum transmitter.
Figure 7 is a block diagram showing one embodiment of spread spectrum receiver.
Figure 8 is a block diagram showing another embodiment of a spread spectrum receiver.
Figure 9 is a scatter diagram comparing transmitted and received I and Q signals.
Figure 10 is a block diagram of an embodiment of a spread spectrum receiver using separable real and imaginary parts of a received spread spectrum signal.
Figures 11A-11F are diagrams showing a representation of transmitted and received waveforms for different phase values.
Figure 12 is a block diagram of another embodiment of a spread spectrum receiver using separable real and imaginary parts of a received spread spectrum signal.
Figure 13A is a block diagram of another embodiment of a spread spectrum receiver using serial correlation for separable real and imaginary parts of the received spread spectrum signal.
Figure 13B is a block diagram of a spread spectrum receiver using multi-bit serial correlation for separable real and imaginary parts of the received spread spectrum signal.
Figure 13C is a graph showing an example of quantization of an I or Q waveform in accordance with the Fig. 13B receiver.
Figure 13D is a block diagram of another embodiment of a spread spectrum receiver using multi-bit serial correlation for separable real and imaginary parts of the received spread spectrum signal.
Figure 14 is a block diagram of a preferred digital circuit embodiment of a set of noncoherent serial correlators and associated receiver components.
Figure 15 is a block diagram of a Robertson device for computing a sum of the squares of its inputs.

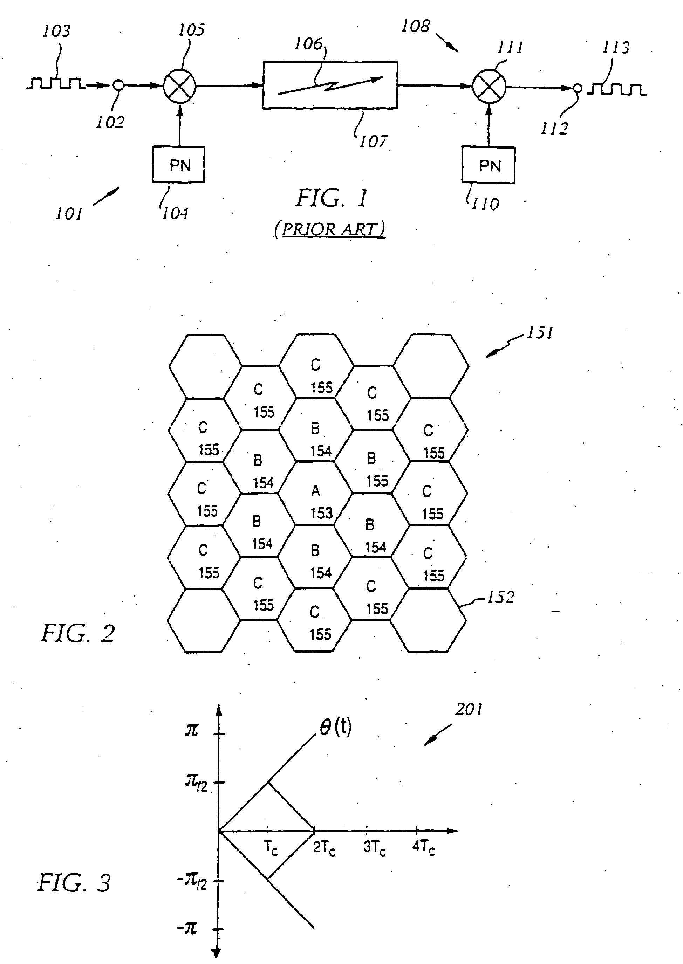

Figure 1 is a block diagram of a spread spectrum communication transmitter 101 and receiver 108 as known in the art.

The spread spectrum transmitter 101 of Fig. 1 comprises an input port 102 for input data 103, a transmitter chip sequence generator 104, and a modulator 105. The transmitter 101 thereby transmits a spread spectrum signal 106 over a transmission channel 107. The transmission channel 107 may comprise an RF channel, but may also comprise other transmission media, such as modulated laser, ultrasound, or fluidic systems. The spread spectrum receiver 108 of Fig. 1 comprises a receiver chip sequence generator 110, a demodulator 111, and an output port 112 for generating output data 113. In the Fig. 1 system, a single chip sequence, which appears essentially random to others not knowing the spreading code upon which it is based, may be identically generated by both the transmitter generator 104 and the receiver generator 110. An extensive discussion of spread spectrum communication, spreading codes, and chip sequences may be found in R. Dixon, Spread Spectrum Systems with Commercial Applications (J. Wiley & Sons, 3d ed. 1994).

Figure 2 depicts a pattern of cells for use in spread spectrum communication.

In the preferred cellular environment of Fig. 2, a region 151 for communication may be divided into a set of cells 152, each of which may be assigned a frequency and a set of spread spectrum codes for communication. A first cell 153 may generally be found adjacent to a set of distance-one neighbors 154 and a set of distance-two neighbors 155. In a preferred embodiment, a plurality of frequencies f1, f2 and f3, and a plurality of code sets c1, c2, and c3, may be configured in a pattern of cells 152 so that the no distance-one neighbors 154 or distance-two neighbors 155 of a particular cell 153 has the same combination of frequency and code set as the cell 153.

Other and further information about a preferred cellular environment in which the invention may operate may be found in US Patent No. 5,402,413.

Known CPM spread spectrum signals include several variations; these include minimum shift keying (MSK) and its variations, e.g., Gaussian pre-filtered MSK (GMSK), superposed quadrature amplitude modulation (SQAM), and staggered quadrature offset raised cosine modulation (SQORC). These variations are known in the art. Explanations of various types of CPM techniques may be found in the following: Frank Amoroso and James A. Kivett, "Simplified MSK Signaling Technique," IEEE Transactions on Communications, April 1977, pp. 433-441; Mark C. Austin and Ming U. Chang, "Quadrature Overlapped Raised-Cosine Modulation," IEEE Transactions on Communications, Vol. Com-29, No. 3, March 1981, pp. 237-249; Kazuaki Murota and Kenkichi Hirade, "GMSK Modulation for Digital Mobile Radio Telephony," IEEE Transactions on Communications, Vol. Com-29, No. 7, July 1981, pp. 1044-1050; and J.S. Seo and K. Feher, "SQAM: A New Superposed QAM Modem Technique," IEEE Transactions on Communications, Vol. Com-33, March 1985, pp. 296-300. The invention is generally described with regard to MSK signals. However, other variants of MSK and other CPM signals are within the scope of the invention.

An MSK signal is generally characterized by the fact that phase changes linearly within' each chip time, and that the phase change over a single chip time is $\pm\pi/2$ radiants ($\pm90$ degrees) . The rate of phase change for a single chip time is $\pm k$, for a suitable value k, and is linear and continuous everywhere except at chip boundaries.

The above described characteristics of MSK signals may be further explained with reference to Fig. 3, which is a graph showing possible changes in phase for an MSK signal over time. In Fig. 3, the x-axis is time and the y-axis is signal phase. In a first chip time from zero to Tc, the phase $\theta(t)$ changes from 0 to $\pi/2$ or $-\pi/2$. In a second chip time, from Tc to 2 Tc, the phase $\theta(t)$ changes from $+\pi/2$ to 0 or $+\pi/2$ to $+\pi$, or from $-\pi/2$ to 0 or $\pi/2$ to $-\pi$, and so on.

An MSK signal s(t) may be considered to comprise two offset signals, i(t) and q(t), which represent the phase of the carrier signal. At any instant of time the phase of the carrier signal may be expressed as:

$$\theta(t) = -\text{Tan}^{-1}[q(t)/i(t)]$$

Thus, i (t) = cos $\theta$ (t) , and q (t) = sin $\theta$ (t).

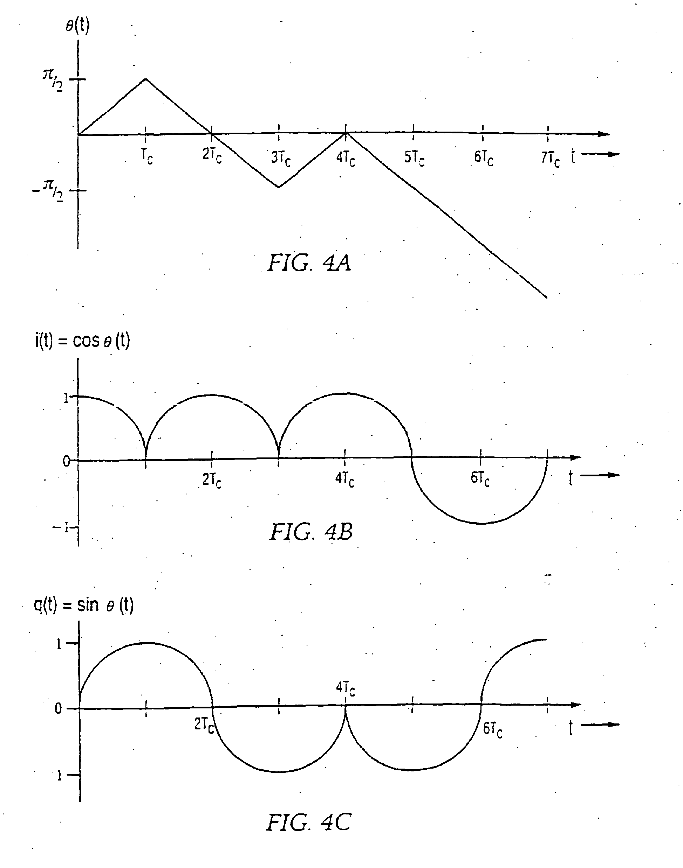

Since the phase of the MSK signal varies linearly from one chip time to the next chip time, i(t) and q (t) may consist of half sinusoidal waveforms as shown in the Figs. 4A-4C. In Figs. 4A-4C, the x-axis is time and the y-axis is signal phase. Figure 4A is a graph showing an example of how the phase $\theta$ (t) may change for a particular MSK signal in each chip time from 0, Tc, 2Tc, 3Tc, 4Tc, 5Tc, and so on, for the chip sequence "11101001...." As noted, during each chip time the phase varies for an MSK signal by $\pi/2$ in either a positive or negative direction. Figures 4B and 4C are graphs showing i (t) and q (t) waveforms, respectively, which correspond to the varying phase $\theta$ (t) . Because of the nature of the MSK signal's phase $\theta$ (t) (e.g., that it is linear and varies only by $\pi/2$ each chip period), the i (t) signal comprises a sequence of partial cosine waveforms, and the q(t) signal comprises a sequence of partial sine waveforms. Each of i(t) and q(t) comprises a half-waveform over a timespan of 2Tc; that is, i(t) and q(t) occur at half the chip rate.

An i(t) waveform and a q(t) waveform can be generated from a chip stream c(t) and combined so as to produce an MSK signal -- i.e., a signal having a phase which varies linearly as desired in either a positive or a negative direction by an amount of $\pi/2$ each chip time. In order to generate i(t) and q(t), the original chip stream c(t) may be demultiplexed into two separate chip streams $C_{even}$ (t) and $C_{odd}$ (t) , each having half the chip rate of the original chip stream c(t). In the described embodiment, the i(t) signal is associated with the odd-numbered chips, and the q(t) signal is associated with the even-numbered chips.

Thus, the i(t) signal comprises a sequence of half-sinusoidal waveforms, one for each odd chip. Each half sinusoid may be positive for a "1" chip and negative for a "0" chip:

$$i(t) = C_{odd}(t) \cos \theta(t) \qquad (203)$$

where $C_{odd}(t)$ comprises the odd-numbered chips from the chip stream to be transmitted. Similarly, the q(t) signal comprises a sequence of half-sinusoidal waveforms, one for each even chip:

$$q(t) = C_{even}(t) \sin \theta(t) \qquad (204)$$

where $C_{even}(t)$ comprises the even-numbered chips from the chip stream to be transmitted.

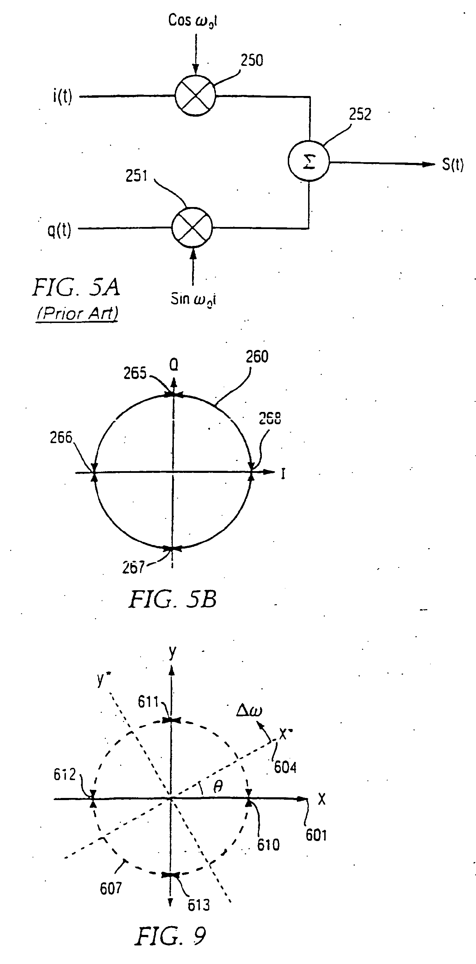

The i(t) and q(t) signals may be used to modulate a carrier signal operating at frequency $\omega_0$ by summing i(t) and q(t) in phase quadrature so as to generate an MSK signal s(t) having a linearly varying phase e(t). A block diagram showing means for generating a CPM spread spectrum signal is depicted in Fig. 5A. The signal i(t) is multiplied with a signal A cos $\omega_0$t by multiplier 250, which provides an output to a summer 252. The signal q(t) is multiplied with a signal A sin $\omega_0$t by multiplier 251, which also provides an output to the summer 252. The summer 252 sums its inputs and produces an output signal s(t).

The relationship between the transmitted signal s(t) having varying phase θ(t), and the i(t) and q(t) signals is shown in the following equations:

$$
\begin{aligned}
s(t) &= Re \{A \exp(j [-\omega_0 t + \theta(t)])\} \\
&= Re \{A \exp(-j\omega_0 t) \exp(j\theta(t))\} \\
&= Re \{A [\cos \omega_0 t - j \sin \omega_0 t] [i(t) + jq(t)]\} \\
&= A\, i(t) \cos \omega_0 t + A\, q(t) \sin \omega_0 t \qquad (207)
\end{aligned}
$$

where A is an amplification factor, Re {} represents the real part of a complex value, and j is the square root of -1. Note that u(t) = i(t) + jq(t) represents the complex envelope of s(t).

As noted herein, i(t) and q(t) each comprises every other chip from the chip stream c(t); i(t) comprises the odd-numbered chips 1, 3, 5, . . . ., q(t) comprises the even-numbered.chips 2, 4, 6, . . . . The transmitted signal s(t), generated from signals i(t) and q(t), therefore comprises all of the chips. Because q(t) is derived from the even chips while i(t) is derived from the odd chips, q(t) is delayed by one chip time from i(t); thus, q(t) and i(t) are offset signals.

It is important to note that, because i(t) and q(t) are staggered, as i(t) reaches its maximum (or minimum) value q(t) will be zero, and vice versa. This relationship between i(t) and q(t) allows phase change sequences of $\pm\pi/2$ over one chip time Tc (unlike, for example, QPSK or OQPSK). Figure 5B is a graph of I and Q values, in which the x-axis represents values of i(t) and the y-axis represents values of q(t). Each <i(t), q(t)> pair falls at a given instant of time on the circle 260. Maximum and minimum values for i(t) and q(t) are shown where the circle 260 intersects the x-axis and y-axis at points 265 through 268; these points 265 through 268 also represent the possible values of <i(t), q(t)> pairs at chip boundary times.

Alternative encoding methods such as GMSK, SQAM, or SQORC, differ from MSK in that phase changes of less than $\pm\pi/2$ are allowed. In general, GMSK, SQAM, and SQORC all use a form of pre-filtering the MSK i(t) and q(t) signals to reduce transmission bandwidth. This pre-filtering has the general effect of reducing the high-frequency components generated by the sharp phase reversals in the MSK i(t) and q(t) signals. For GMSK, pre-filtering may also result in intersymbol interference over several chip times, the effect of which may be mitigated with a trellis decoder. In SQAM or SQORC, the final frequency envelope is no longer constant, but is still nearly so.

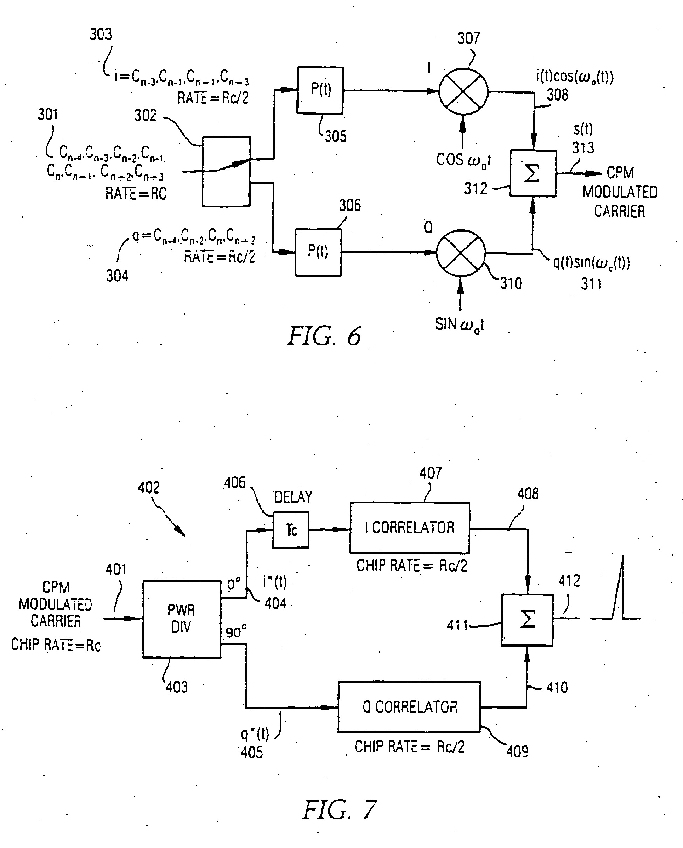

Figure 6 is a block diagram of a spread spectrum transmitter.

In the transmitter of Fig. 6, a chip stream c(t) 301 is provided to a demultiplexer 302, which divides the chip stream 301 into a set of odd chips $C_{odd}(t)$ 303 for the i(t) signal and a set of even chips $C_{even}(t)$ 304 for the q(t) signal. The chip stream c(t) 301 may comprise the result of a pseudo-noise ("PN") code modulated with a data stream (as in direct sequence spread spectrum communication), or may comprise a sequence of chip codes corresponding to predetermined symbols such as may be done, for example, in code shift keying (CSK) techniques. -

The odd chips 303 and the even chips 304 are each coupled to first and second waveform generators P(t) 305 and 306 respectively. In a preferred embodiment, the waveform generators P(t) may generate a half-sinusoidal waveform, positive or negative, as described herein. Other waveform generators and other waveforms are within the scope and spirit of the invention.

The output of the first waveform generator 305 (i.e., receiving the odd chips 303) corresponds to the signal i(t) and is coupled to a first multiplier 307, which modulates a carrier signal cos $\omega_0$t to generate a signal $S_1$(t) 308 corresponding to i(t) cos $w_0$t. The output of the second waveform generator 306 (i.e., receiving the even chips 304) corresponds to the signal q(t), which, as mentioned, is delayed by one chip time Tc from the signal i(t). The output of the second waveform generator 306 is coupled to a second multiplier 310, which modulates a carrier signal sin $w_0$t to generate a signal $S_2$(t) 311 corresponding to q(t) sin $w_0$t.

The signals $s_1$(t) 308 and $s_2$(t) 311 are coupled to a summer 312, which combines its inputs and generates a superposed signal s(t) 313. The signal s(t) may be amplified and transmitted by a transmission system, such as a radio transmission system, coupled to the transmission channel 107.

The chip stream c(t) may be generated by modulating a pseudo-noise code with data to be transmitted such as is known in direct sequence spread spectrum modulation. In a preferred embodiment, the chip stream c(t) comprises a plurality of symbol codes, each symbol code representing a symbol indicative of one or more data bits of information. Instead of directly modulating input data with a pseudo-noise code, sequences of data bits are translated into symbols which are used to select from a plurality of symbol codes located in a table. For example, five data bits may represent a symbol; thus, there may be 32 possible symbols representing all possible combinations of five data bits. Each symbol is associated with a unique symbol code, so that thirty-two symbol codes (or sixteen symbol codes and their inverses) may represent all possible symbols. For each symbol to be transmitted, the appropriate symbol code is selected among the thirty-two available. Thus, the chip stream c(t) may comprise a sequence of symbol codes.

Each symbol code may be, for example, 32 chips in length, or some other appropriate number of chips in length (preferably an even number of chips).

In a like manner, the demultiplexer 302 may comprise a table of half symbol codes. In particular, the demultiplexer 302 may comprise a Q-lookup table and I-lookup table. For every five bits of data to be transmitted (following the previous example), instead of looking up a symbol code from a table and demultiplexing it with demultiplexer 302, two half symbol codes may be read, one from the I-lookup table and one from the Q-lookup table. Each half symbol code may be clocked serially to the waveform generators 305, 306 for further processing. The system may comprise clocking logic which provides a delay of one chip time Tc to the half symbol code from the Q-lookup table.

Once a set of 32 unique symbol codes are selected, the contents of the I-lookup table and Q-lookup table can be generated by dividing each symbol code into even and odd chips, and using the even chips for the half symbol codes in the Q-lookup table and the odd chips for the half symbol codes in the I-lookup table. Other techniques for generating even and odd chip sequences suitable for signals q(t) and i(t) fall within the spirit and scope of the invention.

Figure 7 is a block diagram of a spread spectrum receiver.

The transmitted signal s(t) 313 may undergo attenuation, addition of noise, multipath superposition, and other known and unknown effects of the transmission channel 107. Accordingly, the received signal s*(t) 401 may differ from the transmitted signal s(t) 313 in known and unknown ways.

Received signal s*(t) may be despread using multiple correlators keyed to I and Q chip streams. Because CPM spread spectrum signals may be thought of as the superposition of time staggered signals created from I and Q chip streams (each at half the chip rate), a receiver according to one embodiment of the present invention uses two correlators, one programmed with the I-chip-sequence and one programmed with the Q-chip-sequence and both operating at half the chip rate, to decode the received signal, and then combines the outputs of the two correlators.

In the receiver of Fig. 7, the received signal s*(t) 401 is coupled to a CPM correlator 402 for recognizing a chip sequence in the received signal s*(t) 401. The CPM correlator 402 comprises a power divider 403 for generating duplicate signals, an i*(t) signal 404 with a 0 degree phase delay, and a q*(t) signal 405 with a 90 degree phase shift.

The i*(t) signal 404 is coupled to a delay 406, which delays the i*(t) signal 404 by one chip time Tc to allow simultaneous generation of correlation pulses by the I correlator 407 and the Q correlator 409. Thus, the delayed i*(t) signal is coupled to an I correlator 407, and the q*(t) signal 405 is coupled directly to a Q correlator 409.

The I correlator 407 operates at a chip rate of Rc/2, where Rc is the chip rate (i.e., 1/Tc) of the received signal s*(t) 401. The I correlator 407 may comprise one of several types of correlators, e.g., a surface-acoustical-wave (SAW) correlator, a tapped-delay-line (TDL) correlator, or a serial correlator. Examples of suitable correlators may be found in U.S. Pat-. No. 5, 016, 255 entitled "Asymmetric Spread Spectrum Correlator" or in U.S. Pat. No. 5,022,047 entitled "Spread Spectrum Correlator", both of which are issued in the name of inventors Robert C. Dixon and Jeffrey S. Vanderpool and hereby incorporated by reference as if fully set forth herein. The I correlator 407 produces an output I correlation signal 408 indicating a degree of match between the delayed i*(t) signal and a predetermined I-chip-sequence.

The Q correlator 409 similarly operates at a chip rate of Rc/2, and may similarly comprise any of a number of suitable correlators such as those described in the patents referenced in the preceding paragraph. The Q correlator 409 produces an output Q correlation signal 410 indicating a degree of match between the q*(t) signal and a predetermined Q-chip-sequence.

The I correlation signal 408 and the Q correlation signal 410 are coupled to a summer 411, which combines its inputs and produces a unified correlation signal 412. Because the i*(t) signal is delayed by delay 406, the I correlation signal 408 and Q correlation signal 410 occur simultaneously. The unified correlation signal 412 is used to determine a data stream d(t) from which the chip sequence c(t) was generated.

The I correlator 407 and the Q correlator 409 thus jointly identify the chip sequence in the received signal s*(t) 401. The I correlator 407 is configured to recognize the odd chips of the chip sequence, while the Q correlator 409 is configured to recognize the even chips of the chip sequence. When the entire correlation sequence appears in the received signal s*(t), the sum of the I correlation signal 408 and the Q correlation signal 410 is at a maximum, and may be compared against a predetermined threshold to allow recognition of the chip sequence. A unified correlation signal 412 is produced when a chip sequence is recognized.

Alternatively, instead of comparing the unified correlation signal 412 to a predetermined threshold, a system may be configured so as to have a plurality (e.g., 32) of CPM correlators 402 operating in parallel, each tuned to recognize a different code sequence. The outputs of all 32 CPM correlators may be summed and, when the sum is at a predetermined maximum level, the CPM correlator 402 with the highest magnitude output may be chosen by a best-of-M detector or similar means as indicative of the data stream d(t). For example, in a CSK system, each of 32 CPM correlators may attempt in parallel to recognize a code sequence, and the one with the highest magnitude correlation signal may be assumed to indicate the received chip stream. The recognized chip stream may correspond to a data symbol from which a portion of the data stream d(t) may be recovered.

The CPM correlator 402 may be used in conjunction with techniques described in U.S. Patents 5, 016, 255 or 5, 022, 047, both of which are assigned to the assignee of the present invention . In those techniques, each data bit or data symbol of the data stream d(t) may be encoded by modulation with the entire length of a pseudo random chip sequence generated from a chip sequence code. For example, if a chip sequence code identifies a pseudo random chip sequence that repeats after 32 chips, each data bit of the data stream d(t) may be modulated with all 32 of those chips.

However, there is no requirement that the CPM correlator 402 be used with those particular techniques. For example, the CPM correlator may be used with other spread spectrum techniques to recognize a correlation signal that is used to synchronize the transmitter 101 and the receiver 108. Also, the CPM correlator 402 may be used in conjunction with a self-synchronizing or auto-synchronizing spread spectrum technique such as described elsewhere herein in more detail.

The I and Q chip sequences are preferably of equal length; thus, each CSK symbol code is preferably an even number of chips in length so as to avoid a 90-degree phase uncertainty between symbol codes when despreading is attempted.

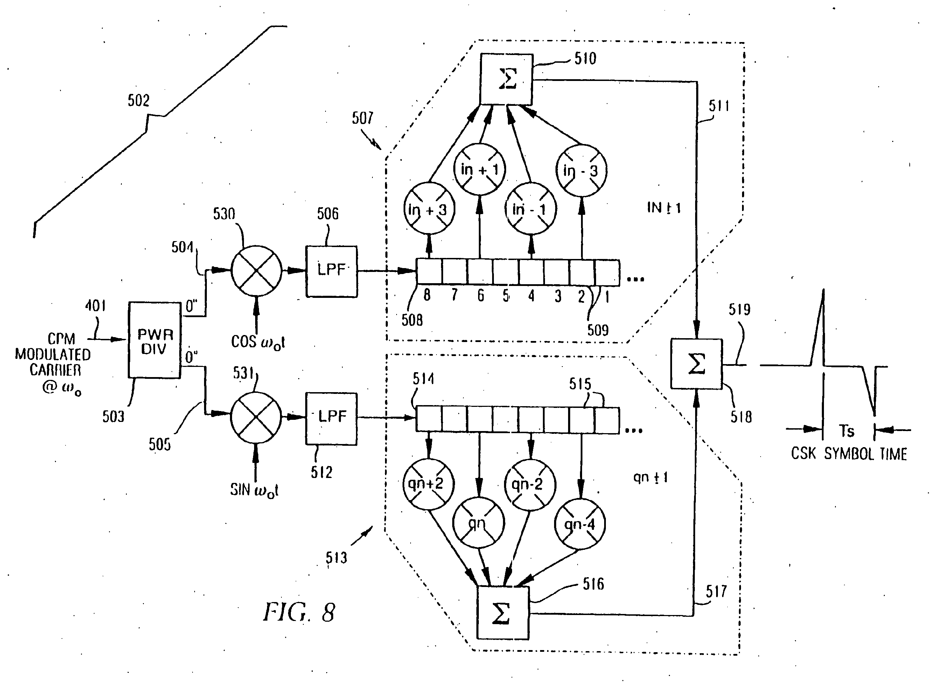

Figure 8 is a block diagram of a coherent spread spectrum receiver.

The received signal s*(t) 401 in the receiver of Fig. 8 is coupled to a CPM correlator 502 for recognizing a chip sequence in the received signal s*(t) 401. The CPM correlator 502 comprises a power divider 503, which produces duplicate signals 504 and 505, each with a 0 degree phase delay. Such power dividers are known in the art and are generally preferred for the CPM correlator 502 over the power divider 403 shown in Fig. 7. While a phase delay of 90 degrees between i*(t) and q*(t) was imposed by use of the power divider 403 in Fig. 7, a 90-degree phase delay in the Fig. 8 embodiment is produced by separately multiplying the signals 504 and 505 with cosine and sine signals, respectively.

The signal 504 is multiplied with a $\cos w_0 t$ signal by I multiplier 530 and filtered by a I low pass filter 506 to provide an i*(t) signal. The signal 505 is multiplied by a $\sin \omega_0 t$ signal by Q multiplier 531 and filtered by a Q low pass filter 512 to provide a q*(t) signal.

The outputs of the I low pass filter 506 and the Q low pass filter 512 generally appear for MSK as half sinusoidal waveforms corresponding to those generated in the transmitter from P(t) generators 305, 306.

The i*(t) signal output from I low pass filter 506 is coupled to an I correlator 507. The I correlator 507 comprises a register 508 having a sequence of chips 509. The register 508 may be an analog shift register, a tapped delay line having a plurality of taps, or any other suitable storage means. The odd chips are coupled by a plurality of multipliers to an I summer 510, which combines its inputs and produces an output I correlation signal 511.

An example of the path of the I correlator 507 is shown in Fig. 23. As described with respect to Fig. 8, the filtered i* (t) signal is coupled to a register 508. The register 508 comprises a series of chips 509 along which the filtered i*(t) signal propagates. The register 508 is matched to a particular code sequence. Thus, in the example of Fig. 23, the sequence of odd chips which will result in a match is $C_{odd}(t)$ = 11001000. At time t = 16Tc, the first chip $C_1$ is compared with the first chip in the sequence of $C_{odd}$ (t) , and a "1" is generated if the chips are equal. Each of the other odd chips in the register 508 is likewise compared against the programmed sequence. A comparison between any two chips may be carried out using a multiplier or an exclusive-OR gate. The comparison values are provided to' a summer 510 which generates a maximum pulse when the chip sequence for which the correlator 507 has been programmed matches the received chip-Sequence. In Fig. 23, the branches having a "-1" correspond to chips for which a "0" in the received chip sequence will generate a match, while the other branches correspond to chips for which a "1" in the received chip sequence will generate a match.

Returning to Fig. 8, the q*(t) signal output from the Q low pass filter 512 is coupled to a Q correlator 513. The Q correlator 513 similarly comprises a register 514 having a sequence of chips 515. As with the odd chips in the I correlator 507, the even chips are coupled to a Q summer 516, which combines its inputs and produces an output Q correlation signal 517.

The I correlation signal 511 and the Q correlation signal 517 are coupled to a summer 518, which combines its inputs and produces a unified correlation signal 519. Because the I correlation signal 511 is derived from the odd chips while the Q correlation signal 517 is derived from the even chips (which precede the odd chips by one chip time Tc), the correlation signals 511, 517. occur simultaneously, and there is no need for a separate delay element such as delay 406 shown in Fig. 7. The unified correlation signal 519 is used to determine a data stream d(t) from which the chip sequence c(t) was generated in a manner similar to that explained above with reference to Fig. 7.

The Fig. 8 receiver operates best with a coherent carrier reference at frequency $\omega_0$ and assumes such is available. Methods are known in the art for obtaining a coherent carrier reference, such as the use of phase estimating circuitry. Where very rapid acquisition times are necessary, such as in certain high-speed time division multiple access (TDMA) systems using CPM spread spectrum techniques, other embodiments (such as the non-coherent receiver embodiments described herein) may generally be preferred.

In a non-coherent CPM system, the receiver 106 of Fig. 1 may not have available an exact copy of the carrier signal at frequency $\omega_0$ used by the transmitter 101. Rather, the receiver 108 generates a local carrier signal having a frequency $\omega_1$, which in practice may differ in frequency and phase from the transmitter's carrier signal:

$$\cos \omega_1 t = \cos (\omega_0 + \Delta\omega)t + \theta \qquad (603)$$

where $\Delta\omega$ = frequency difference and $\theta$ = phase difference.

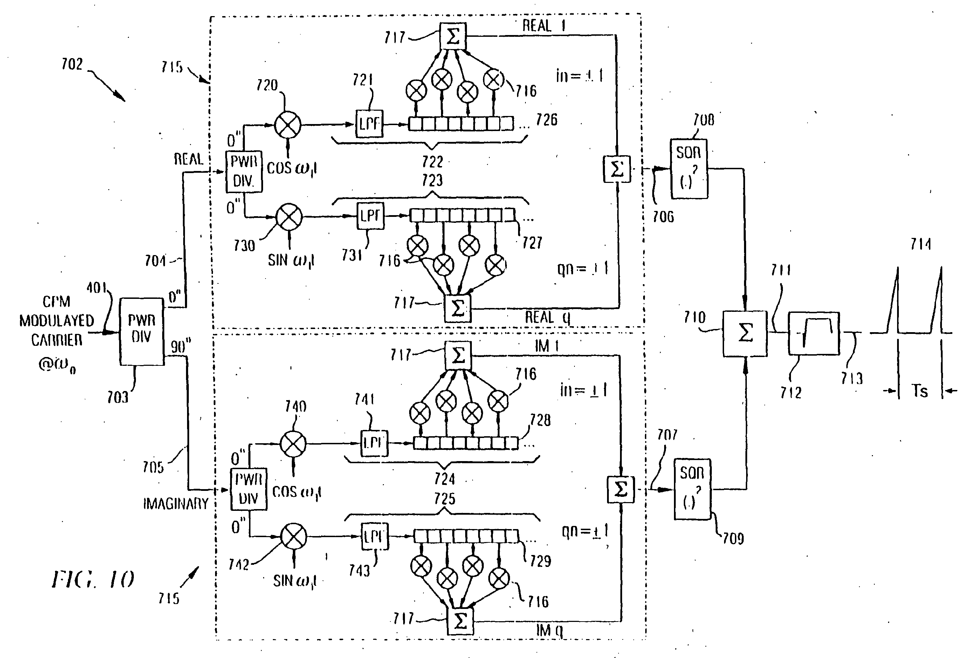

Figure 10 is a block diagram of a non-coherent spread spectrum receiver for receiving and despreading a CPM spread spectrum signal without the need for a locally generated coherent reference signal $\omega_0$. The receiver of Fig. 10 can be used to process a received CPM signal by splitting the received spread spectrum signal into separable real and imaginary parts, splitting the real and imaginary parts into I and Q portions, mixing the real I and Q portions and the imaginary I and Q portions with a non-coherent reference signal having a frequency near that expected of the received signal to obtain real I and Q streams and imaginary I and Q streams, filtering the multiplied signals, correlating separately the I and Q streams for each of the real and imaginary parts to obtain a real I and Q correlation pulse and an imaginary I and Q correlation pulse, combining the I and Q correlation pulses separately for the real and imaginary parts to provide a combined real and a combined imaginary correlation signal, squaring the combined real and imaginary correlation signals to generate a squared real and a squared imaginary correlation pulse, and combining the squared real and imaginary correlation signals into a unified correlation signal.

The operation of the receiver of Fig. 10 may be explained graphically with reference to Fig. 9, which is a scatter diagram comparing real and imaginary values as transmitted and as received in a non-coherent receiver. For simplicity, the explanation below assumes the transmission channel to be distortionless and have unlimited bandwidth. The transmitter's coordinate system 601 is represented by an x-axis and y-axis, with the x-axis representing values of i(t) and the y-axis representing values of q(t). A set of four points 610 through 613 represents transmitted sampled value pairs for $< i(t_n), q(t_n)>$. The pairs 610 through 613 represent coordinates <1,0>, <0,1>, <-1, 0>, and <0,-1>, respectively.

A receiver's coordinate system 604 is represented by an x*-axis and a y*-axis shown as dashed lines in Fig. 9. The receiver's coordinate system 604 is assumed to differ from the transmitter's coordinate system 601 due to frequency and phase differences. The receiver's coordinate system 604 rotates with respect to the transmitter's coordinate system 601 at a rate proportional to $\Delta\omega$, the frequency difference ("beat frequency") between the transmitter and receiver reference signals. For sufficiently small $\Delta\omega$ (such as may be expected for the time period of interest over which correlation for a data symbol will occur -- e.g., 32 chip periods), the receiver's coordinate system 604 approximately equals the transmitter's coordinate system 601, except for a phase difference e which remains relatively constant for short periods of time. In order to maintain such a condition, the beat frequency $\Delta\omega$ preferably should be less than about 1/4 the symbol rate. For example, with a symbol rate of 156.25k symbols/second (5 Mchips/second), the beat frequency $\Delta\omega$ should be less than about 39 kHz for optimal operation.

Because the receiver's coordinate system 604 at a given instant appears rotationally shifted with respect to the transmitter's coordinate system 601, the $<i^*(t_n), c^*(t_n)>$ sampled pair recognized by the receiver 108 will be a point on the circle 607 corresponding to an $< i(t_n), q(t_n)>$ sampled pair in the transmitter's coordinate system 601 but shifted around circle 607 by an amount dependent on the phase difference6. Accordingly, the perceived real value or i*(t) will differ from the transmitted i(t) value by an amount dependent upon cos e due to the rotational difference between the coordinate systems 601 and 604, while the perceived imaginary value or q*(t) will also differ from the transmitted q(t) value by an amount dependent upon sin $\theta$ for the same reason. Thus, if the transmitted <i(n), q(n)> sampled values are <1, 0> and the phase offset $\theta$ is +30°, the received $<i^*(t_n), q^*(t_n)>$ sampled values are <cos -+30°, sin +30°> or <0.866, 0.5>. Likewise, if the phase offset $\theta$ is +90° for the same transmitted values, the received $<i^*(t_n), q^*(t_n)>$ sampled values

are <0, 1>.

From the above explanation, it is apparent that a correlator attempting to correlate for I and -Q portions would be faced with a diminishing i*(t) value as θ varies from 0 to 90 degrees, yet at the same time an increasing q*(t) value. As θ grows, eventually the difference between <i (t) , q (t) > and <i* (t) , q* (t) > becomes so large that accurate correlation is cumbersome. Because of the phase difference θ, it is generally not possible to know in advance which quadrant of Fig. 9 the received, signal s*(t) will be in relative to the transmitter coordinate system 601. However, the present invention in one aspect addresses this problem by utilizing both real and imaginary parts of I and Q portions in order to despread the received s* (t) signal.

It may be noted that as the real portion of i*(t) decreases as θ varies from 0 to 90 degrees, the imaginary portion of i*-(t) increases. Similarly, as the real portion of i*(t) increases (in magnitude) as θ varies from 90 to 180 degrees, the imaginary portion of i*(t) decreases. A similar phenomenon occurs with the real and imaginary portions of q* (t). The receiver of Fig. 10 takes advantage of the complementary aspects of the real and imaginary portions of the received i* (t) and c*(t) signal portions, and accordingly analyzes both the real and imaginary parts of the I and Q signals in order to make an effective correlation.

In the Fig. 10 embodiment, the received signal s*(t) 401 is coupled to a non-coherent CPM correlator 702 for recognizing a correlation sequence in the received signal s*(t) 401. The non-coherent CPM correlator 702 comprises a power divider 703, which produces duplicate signals Real *(t) 704 having a 0-degree phase delay and Imag* (t) 705 having a 90-degree phase delay. Real*(t) 704 and Imag*(t) 705 may be viewed as the real and imaginary parts of the received signal s*(t) 401.

The Real*(-t) signal 704 is coupled to a CPM correlator 715 similar to CPM correlator 502 of Fig. 8, with the exception that the local reference signal is different, as described below. The CPM correlator 715 produces a real correlation signal 706. The Imag* (t) signal is coupled to a second CPM correlator 715 which produces an imaginary correlation signal 707. The real correlation signal 706 is coupled to a squaring device 708, which computes the square of its input. The imaginary correlation signal 707 is likewise coupled to a squaring device 709, which computes the square of its input. The outputs of the squaring devices 708 and 709 are coupled to a summer 710, which combines its inputs to produce a unified correlation signal 711 which is the sum of the squares of the real correlation signal 706 and the imaginary correlation signal 707. The unified correlation signal 711 is coupled to a square root device 712 which takes the square root of its input, and generates a final correlation-signal 713 comprising correlation pulses 714. The time between correlation pulses 714 may be one symbol code time period Ts if CSK is employed.

A primary differences between the CPM correlators 715 shown in Fig. 10 and the CPM correlator 502 of Fig. 8 is that the CPM correlators 715 of Fig. 10 utilize non-coherent reference signals $\cos \omega_1 t = \cos (\omega_0 + \Delta\omega)t + \theta$ and $\sin \omega_1 t = \sin (\omega_0 + \Delta w) t + \theta$ for the I and Q portions, respectively, rather than $\cos \omega_0 t$ and $\sin \omega_0 t$ as generated in the coherent receiver of Fig. 8. The reference signals $\cos \omega_1 t$ and $\sin \omega_1 t$ may be generated from the same oscillator coupled to a power divider to keep the phase offset θ the same for both $\cos \omega_1 t$ and $\sin \omega_1 t$. The use of non-coherent reference signals causes the correlation signal generated by each CPM correlator 715 to have a magnitude dependent in part upon the phase difference θ.

The effect of using non-coherent reference signals on the ability to achieve correlation may be explained first with reference to the I portion of the Real*(t) signal 704. The Real*(t) signal 704 may be represented as:

$$\text{Real*(t)} = \text{Re} \{A \, u(t) \, \exp(-j\omega_0 t)\}$$

where, as mentioned previously, u(t) = i(t) + jq(t), which is the complex envelope of s(t), and Re {} denotes the real portion of a complex value. The Real*(t) signal 704 is multiplied by multiplier 720 with a locally generated reference signal $\cos \omega_1 t = \cos (\omega_0 + \Delta\omega)t + \theta$, so that the output of multiplier 720 is:

$$\text{Re} \{A \, u(t) \, \exp(-j\omega_0 t)\} \, \cos \omega_1 (t)$$

The output of the multiplier 720 is coupled to a low pass filter 721 which retains the baseband portion of the signal coupled to its input. Assuming that the non-coherent reference signal $\cos \omega_1 t$ differs from the transmitter reference frequency $\omega_0$ by only a phase difference (i.e., that the frequency change is negligible over the time period of interest), then the receiver reference signal may be expressed as :

$$\cos \omega_1 t = \cos (\omega_0 t + \theta)$$

The output y(t) of the low pass filter 721 may therefore be expressed as:

$$
\begin{aligned}
y(t) &= \text{LPF} \left[ \text{Re}\{A\, u(t)\, \exp(-j\omega_0 t)\}\, \cos \omega_1(t) \right] \\
&= \text{LPF} \left[ \text{Re}\{A\, u(t)\, \exp[j(-\omega_0 t + \omega_1 t)]\} \right] \\
&= (A/2)\, i(t)\, \cos(\omega_0 + \omega_1 t)t + (A/2)\, q(t)\, \sin(\omega_0 t + \omega_1 t) \\
&= (A/2)\, i(t)\, \cos(-\theta) + (A/2)\, q(t)\, \sin(-\theta) \\
&= (A/2)\, i(t)\, \cos\theta - (A/2)\, q(t)\, \sin\theta \qquad\qquad (790)
\end{aligned}
$$

where "LPF" denotes operation of the low pass filter 721.

By similar deduction the output z(t) of the low pass filter 731 of the Q portion of the Real*(t) signal is as follows:

$$
\begin{aligned}
z(t) &= (A/2)\, i(t)\, \sin(-\theta) + (A/2)\, q(t)\, \cos(-\theta) \\
&= (-A/2)\, i(t)\, \sin\theta + (A/2)\, q(t)\, \cos\theta \qquad\qquad (791)
\end{aligned}
$$

Due to the 90-degree phase shift in signal 705, the output of low pass filter 741 of the I portion of the Imag* (t) signal is equal to z(t) as derived above, while the output of low pass filter 743 of the Q portion of the Imag*(t) signal is equal to the inverse of y(t) as derived above. In operation, each of the four correlators 722 through 725 may contribute to correlation of the received CPM signal s*(t). Operation of the non-coherent CPM correlator 702 may be shown through several examples. As a first example, assume that the phase offset $\theta = 0°$; therefore, the outputs y(t) and z(t) for low pass filters 721 and 731, respectively, reduce to the following:

$$
y(t) = (A/2)\, i(t)
$$

and

$$
z(t) = (A/2)\, q(t)
$$

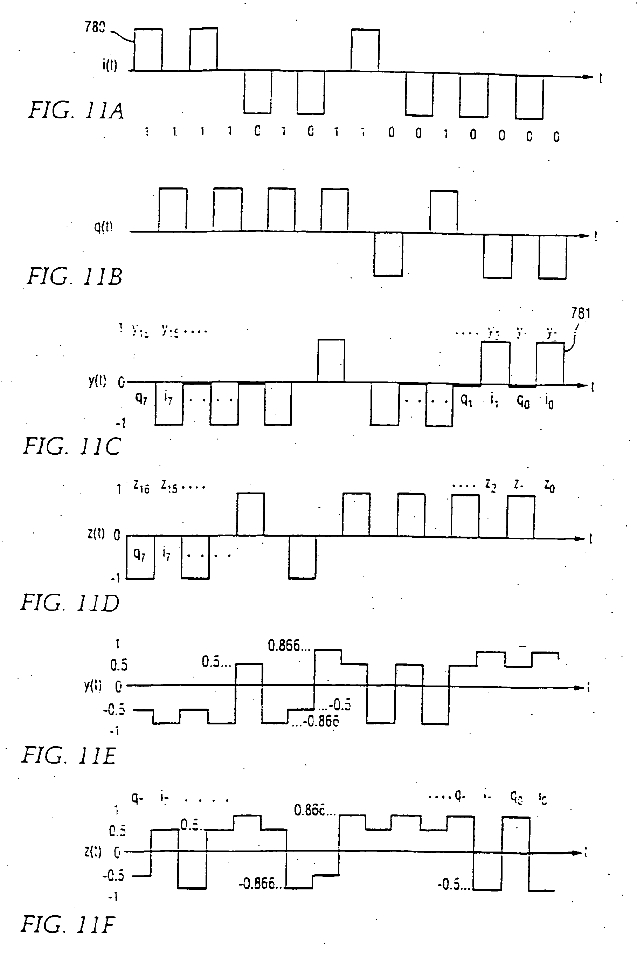

Selecting an amplification factor A = 2, the filter outputs of filters 721 and 731 then become y (t) = i(t) and z(t) = q(t). Assuming, for convenience, a code sequence length of 16 chips, then after 16 chip times (i.e., 16Tc) the entire sequence is contained within the correlation registers 726, 727, 728, and 729 in each CPM correlator 705. An illustrative chip stream c(t) = 1111010110010000 may be broken into sub-sequences $C_{odd}(t) = 11001000$ and $C_{even}(t) = 11110100$. It will further be assumed for sake of explanation that the waveform generator P(t) of the transmitter generates a return-to-zero (RZ) rectangular waveform having a duration of two chip periods, so that the transmitted i(t) and q(t) signals may be depicted as shown in Figs. 11A and Fig. 11B, respectively. Operation of the Fig. 10 correlator using CPM baseband signals instead of RZ signals can be understood by observing that at time t = 16Tc, the peak values of the sinusoidal waveforms appear in the correlation registers 726, 727, 728 and 729, and correspond to the pulse height of the RZ waveform.

At the receiving end, the contents of the correlation registers 726 and 727 may be represented as shown in Figs. 11C and 11D, respectively. It can be seen that the waveform of Fig. 11C as reading from right to left is the same as that of Fig. 11A as reading from left to right. Similarly, the waveforms of Figs. 11B and 11D bear the same relationship. An output for each of the four correlators 722, 723, 724 and 725 may be obtained by pointwise multiplication of the chip values with the chip weighting factors 716 for each chip, and summation of the chip products by summers 717 to produce a correlation signal. The chip weighting factors 716 for correlator 725 are opposite in sign to the values for correlator 723. The chip weighting factors 716 for correlators 722 and 724 are the same sign.

Continuing with the present example in which $\theta = 0°$; the output at time t = 16Tc for each of correlators 722 and 723, corresponding respectively to the I portion ("ReI") and the Q portion ("ReQ") of the Real*(t) signal, is eight, while the output for each of correlators 724 and 725, corresponding respectively to the I portion ("ImI") and the Q portion ("ImQ") of the Imag*(t) signal, is 0. The final correlation, signal 713 at the instant 16Tc is:

$$\mathrm{Corr}\ (t\ =\ 16Tc)\ =\ \{\ (\mathrm{ReI}\ +\ \mathrm{ReQ})^2\ +\ (\mathrm{ImI}\ +\ \mathrm{ImQ})^2\ \}^{1/2}$$
$$=\ \{\ (8\ +\ 8)^2\ \}^{1/2}\ =\ 16$$

The value of 16 is a maximum value indicating correlation, for the particular chip sequence. If multiple codes are to be recognized, a plurality of non-coherent CPM correlators 702 may operate in parallel, each programmed to recognize a different code. The chip sequence corresponding to the highest correlation signal may be selected as the received chip sequence.

Assuming as a second example that $\theta$ = 30°, the convenes of correlation registers 726 and 727 appear as shown in Figs. 11E and 11F, respectively. Selecting the amplification factor A = 2, the outputs y(t) and z(t) of low pass filters 721 and 731, respectively, may be represented as:

$$y(t)\ =\ (A/2)\ i(t)\ \cos(30°)\ -\ (A/2)\ q(t)\ \sin(30°)$$
$$=\ i(t)\ (0.866)\ -\ q(t)\ (0.5)$$

and

$$z(t)\ =\ (-A/2)\ i(t)\ \cos(30°)\ +\ (A/2)\ q(t)\ \sin(30°)$$
$$=\ -i(t)\ (0.5)\ +\ q(t)\ (0.866)$$

Pointwise vector multiplication of each of the chip valves in the correlation registers 726 through 729 with corresponding chip weights 716 yields the following outputs from summers 717:

$$\mathrm{ReI}\ =\ (1)(0.866)\ +\ (1)(0.866)\ +\ (-1)(-0.866)\ +\ (-1)(-0.866)$$
$$\ldots\ =\ (8)(0.866)\ =\ 6.928$$

$$\mathrm{ReQ}\ =\ (1)(0.866)\ +\ (1)(0.866)\ +\ (1)(0.866)\ \ldots\ =\ (8)(0.866)$$
$$=\ 6.928$$

$$\mathrm{ImI}\ =\ (1)(-0.5)\ +\ (1)(-0.5)\ +\ (-1)(0.5)\ +\ (-1)(0.5)$$
$$\ldots$$
$$=\ -(8)(0.5)\ =\ -4.0$$

$$\mathrm{ImQ}\ =\ (1)(-0.5)\ +\ (1)(-0.5)\ +\ (1)(-0.5)\ +\ (1)(-0.5)$$
$$\ldots$$
$$=\ -(8)(0.5)\ =\ -4.0$$

A final correlation signal 713 therefore is generated:

$$\text{Corr} \ (t = 16Tc) = \{ \ (6.928 + 6.928)^2 + (-4 + -4)^2 \ \}^{1/2}$$
$$= 16$$

Thus, for a phase offset of $\theta = 30°$, the value of the final correlation signal 713 at $t = 16Tc$ remains at the maximum level of 16.

As another example, a phase offset $\theta = 45°$ is assumed. The outputs y(t) and 2(t) of low pass filters 721 and 731, respectively, become:

$$y(t) = i(t) \ (0.707) - q(t) \ (0.707)$$

and

$$z(t) = -i(t) \ (0.707) + q(t) \ (0.707)$$

Solving for the intermediate values ReI, ReQ, ImI, and ImQ yields:

$$\text{ReI} = (1) \ (0.707) + (1)(0.707) \ \ldots = (8)(0.707) = 5.657$$

$$\text{ReQ} = (1) \ (0.707) + (1)(0.707) \ \ldots = (8)(0.707) = 5.657$$

$$\text{ImI} = (1)(-0.707) + (1)(-0.707) \ \ldots = -(8)(0.707) = -5.657$$

$$\text{ImQ} = (1)(-0.707) + (1)(-0.707) \ \ldots = -(8)(0.707) = -5.657$$

A final correlator signal 713 is generated:

$$\text{Corr} \ (t = 16Tc) = \{ \ (2 \times 5.657)^2 + (2 \times -5.657)^2 \ \}^{1/2} = 16$$

Again, maximum correlation of 16 is realized even though the phase offset $\theta$ is not equal to 0.

A table can be constructed of (ReI + ReQ), (ImI + ImQ) values and correlation values versus phase offset $\theta$ for the correlator of Fig. 10:

| $\theta$ | $R_i + R_q$ | $I_i + I_q$ | Corr= |
|---|---|---|---|
| 0° | 16 | 0.0 | 16.0 |
| 30 | 13.856 | -8.0 | 16.0 |
| 45 | 11.314 | -11.314 | 16.0 |
| 60 | 8.0 | -13.856 | 16.0 |

(continued)

| θ | $R_i + R_q$ | $I_i + I_q$ | Corr= |
|---|---|---|---|
| 90 | 0.0 | -16.0 | 16.0 |
| 120 | -8.0 | -13.856 | 16.0 |
| 135 | -11.314 | -11.314 | 16.0 |
| 150 | -13.856 | -8.0 | 16.0 |
| 180 | -16.0 | 0.0 | 16.0 |
| 210 | -13.856 | 8.0 | 16.0 |
| 225 | -11.314 | 11.314 | 16.0 |
| 240 | -8.0 | 13.856 | 16.0 |
| 270 | 0.0 | 16.0 | 16.0 |
| 300 | 8.0 | 13.856 | 16.0 |
| 315 | 11.314 | 11.314 | 16.0 |
| 330 | 13.856 | 8.0 | 16.0 |

As the phase offset θ increases beyond 45°, a higher percentage of the correlation value begins to come from the Imag*(t) signal path 705 rather than the Real*(t) signal path 704 of the non-coherent CPM correlator 702. At a phase offset of θ = 90°, for example, all correlation is coming from the Imag*(t) signal path 705 and none from the Real*(t) signal path 704. The output 706 of the real CPM correlator 715 and output 707 of the imaginary CPM correlator 715 progress sinusoidally as a function of the phase offset θ and can be expressed as:

$$\text{Real*(t) correlation} \ = \ 16 \cos \theta$$

$$\text{Imag*(t) correlation} \ = \ -16 \sin \theta$$

$$\text{Corr} \ = \ \{ (16 \cos \theta)^2 + (-16 \sin \theta)^2 \}^{1/2} \ = \ 16$$

Thus, maximum correlation of 16 will be achieved regardless of the phase offset θ. The use of multiple correlators as configured in the manner shown in Fig. 10 allows successful correlation regardless of which quadrant of Fig. 9 the receiver operates with respect to the transmitter.

It should be noted that at chip times other than multiples of 16Tc (for the example of chip sequence of 16 chips), the correlation output will be a function of the cross correlation value between the i $(t_n)$ and q $(t_n)$ subcodes. The non-coherent CPM correlator of Fig. 10 should perform no worse as far as cross-correlation than a bi-phase correlator with the same code. In other words, if a given code produces a maximum time sidelobe value of 4/16 through bi-phase correlation, then the worst time sidelobe to be expected from the Fig. 10 correlator should also be 4/16.

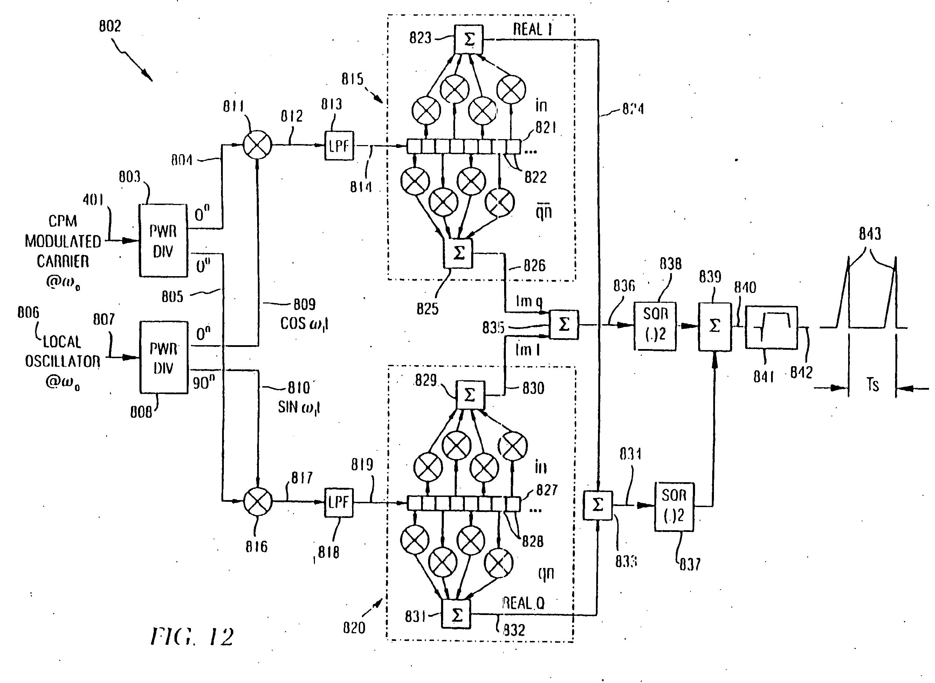

Figure 12 is a block diagram of another embodiment of a non-coherent spread spectrum correlator using separable real and imaginary parts of the received spread Spectrum signal. The Fig. 12 correlator uses only two shift registers instead of four shift registers and uses only a single power divider having no imposed phase delay for operating on the received signal s*(t) as opposed to three power dividers in the non-coherent correlator illustrated in Fig. 10. The use of a power divider having no imposed phase delay on the received signal s*(t) is an advantage because power dividers which impose a phase delay on the typically operate optimally over only a relatively narrow bandwidth, while the received signal may cover a relatively wide bandwidth.

In Fig. 12, the received signal s*(t) 401 is coupled to a two-register non-coherent CPM correlator 802 for recognizing a chip sequence in the received signal s*(t). The two-register non-coherent CPM correlator 802 comprises a first power divider 803, which produces duplicate signals 804 and 805, each with a 0-degree phase delay. A local oscillator 806 produces a local carrier signal $\cos \omega_1 t$ 807, which is coupled to a second power divider 808. The second power divider 808 produces duplicate signals, one signal 809 with a 0-degree phase delay, and another signal 810 with a 90-degree phase delay. The use of the second power divider 808 to generate signals $\cos \omega_1$ and $\sin \omega_1$ from the same local oscillator 806 maintains the phase offset θ between $\omega_1$ and $\omega_0$ for both $\cos \omega_1$ and $\sin \omega_1$.

The signals 804 and 809 are coupled to a first multiplier 811, which combines its inputs and produces a first product signal 812. The first product signal 812 is coupled to a first low pass filter 813, which produces a first filtered signal 814 which retains its baseband frequency components. The first filtered signal 814 is coupled to a first even-odd correlator 815.

The signals 805 and 810 are similarly coupled to a second multiplier 816, which combines its inputs and produces a second product signal 817. The second product signal 817 is similarly coupled to a second low pass filter 818, which produces a second filtered signal 819 which retains its baseband frequency components. The second filtered signal 819 is similarly coupled to a second even-odd correlator 820.

In the two-register non-coherent CPM correlator 802 depicted in Fig. 12, the Q portion of the Real * (t) signal is the same as the I portion of the Imag*(t) signal, and the Q portion of the Imag*(t) signal is 180-degrees out of phase (i.e., the inverse) of the I portion of the Real*(t) signal. The I portion of the Real* (t) signal and the Q portion of the Imag* (t) signal are stored in and read from the same register 821. Similarly, the I portion of the Imag* (t) signal and the Q portion of the Real* (t) signal are stored in and read from the same register 827. The two-register-non-coherent CPM correlator. 802 of Fig. 12 operates in a conceptually similar manner to the non-coherent CPM correlator 702 of Fig. 10.

The first even-odd correlator 815 simultaneously recognizes the real i* (t) components and the imaginary q*(t) components, and comprises a register 821 capable of holding a sequence of chips 822. The odd chips are coupled to a real I summer 823, which combines its inputs and produces a real I correlation signal 824. The even chips are coupled to an imaginary Q summer 825, which combines its inputs and produces an imaginary Q correlation signal 826.

The second even-odd correlator 820 simultaneously recognizes the imaginary i*(C) components and the real q*(t) components, and comprises a register 827 capable of holding a sequence of chips 828. The odd chips are coupled to an imaginary I summer 829, which combines its inputs and produces an imaginary I correlation signal 830. The even chips are coupled to a real Q summer 831, which combines its inputs and produces a real Q correlation signal 832.

The real I correlation signal 824 and the real Q correlation signal 832 are coupled to a real summer 833, which combines its inputs and produce a real correlation signal 834. Similarly, the imaginary Q correlation signal 826 and the imaginary I correlation signal 830 are coupled to an imaginary summer 835, which combines its inputs and produces an imaginary correlation signal 836.

The real correlation signal 834 is coupled to a squaring device 837, which computes the square of its input. The imaginary correlation signal 836 is coupled to a squaring device 838, which computes the square of' its input. The two squared values are coupled to a summer 839, which combines its inputs and produces a unified correlation signal 840 representing the sum of the squares of the real correlation signal 834 and the imaginary correlation signal 836. The unified correlation signal 840 is coupled to a square root device 841 which takes the square root of its input and generates a final correlation signal 842. The squaring devices 837 and 838, the summer 839, and the square root device 841 collectively compute the root of the sum of the squares of the real and imaginary signals. A Robertson device such as depicted in Fig. 22 and described elsewhere herein may be used to estimate the root of the sum of the squares. The time between separate correlation pulses 843 may be one symbol code time period Ts if CSK is used.

It should be noted that in the non-coherent CPM correlator 702 of Fig. 10 and the two-register non-coherent CPM correlator 802 of Fig. 12, the process of squaring destroys polarity information.

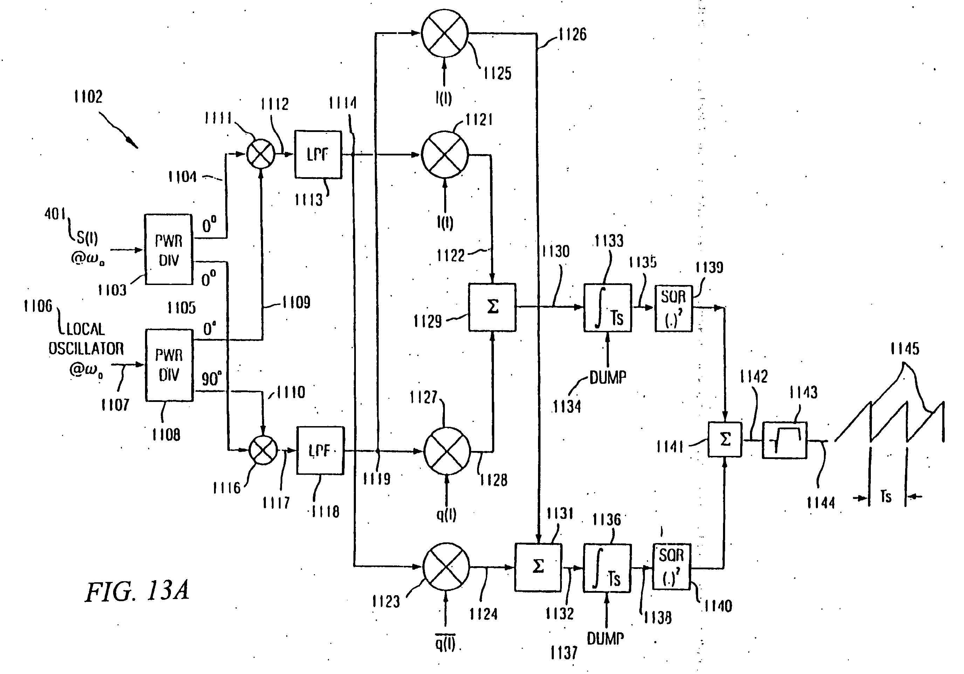

Figure 13A is a block diagram of a non-coherent spread spectrum receiver using serial correlation for separable real and imaginary parts of the received spread spectrum signal.

The received signal s*(t) 401 is coupled to a dual-integrator non-coherent serial CPM correlator 1102 for recognizing a chip sequence in the received signal s* (t) 401. The dual-integrator non-coherent serial CPM correlator 1102 comprises a first power divider 1103, which produces duplicate signals 1104 and 1105, each with a O-degree phase delay. A local oscillator 110.6 produces a local carrier signal cos $\omega_1$t 1107, which is coupled to a second power divider 1108. The second power divider 1108 produces duplicate signals, one signal, 1109 with a 0-degree phase delay, and another signal, 1110 with a 90-degree phase delay.

The signals 1104 and 1109 are coupled to a first multiplier 1111, which combines its inputs and produces a first product signal 1112. The first product signal 1112 is coupled to a first low pass filter 1113, which produces a first filtered signal 1114 retaining its baseband frequency components.

The signals 1105 and 1110 are coupled to a second multiplier 1116, which combines its inputs and produces a second product signal 1117. The second product signal 1117 is coupled to a second low pass filter 1118, which produces a second filtered signal 1119 retaining its baseband frequency components.

In dual-integrator non-coherent serial CPM correlator 1102, the Q portion of the Real* (t) signal is the same as the portion of the Imag* (t) signal, and the Q portion of the Imag* (t) signal is 180-degrees out of phase (i.e., the inverse) of the I portion of the Real*(t) signal.

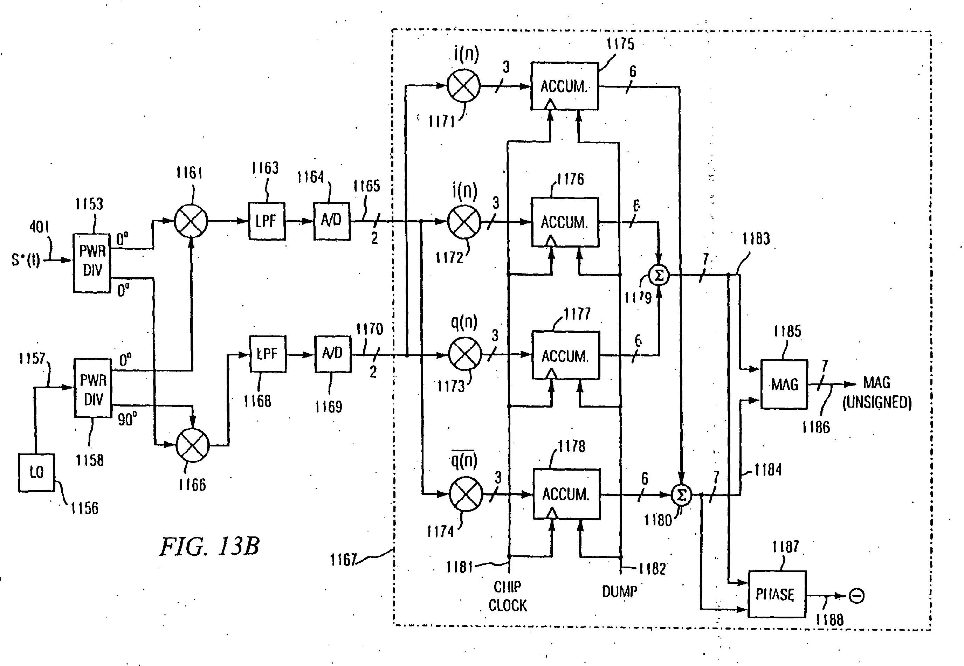

First filtered signal 1114 is coupled to a real I multiplier 1121, which is also coupled to a locally generated signal i(t), that is, the i(t) chip sequence of the correlation sequence (see Fig. 13B). The real I multiplie= 1121 combines its inputs and produces a real I product signal 1122.

The first filtered signal 1114 is also coupled to an imaginary Q multiplier 1123, which is also coupled to a locally generated signal q(t), that is, the inverted q(t) chip sequence of the correlation sequence (see Fig. 13B). The imaginary Q multiplier 1123 combines its inputs and produces an imaginary Q product signal 1124.

The second filtered signal 1119 is coupled to an imaginary I multiplier 1125, which is also coupled to the locally generated signal i (t) The imaginary I multiplier 1125 combines its inputs and produces an imaginary I product signal 1126.

The second filtered signal 1119 is also coupled to a real Q multiplier 1127, which is coupled to a locally generated signal q(t), that is, the q(t) chip sequence of the correlation sequence (see Fig. 13B). The real Q multiplier 1127 combines its inputs and produce a real Q produce signal 1128.

The real I product signal 1122 and the real Q product signal 1128 are coupled to a real summer 1129, which combine its inputs and produces a real product signal 1130. The imaginary Q product signal 1124 and the imaginary I product signal 1126 are coupled to an imaginary summer 1131, which combines its inputs and produces an imaginary product signal 1132.

The real product signal 1130 is coupled to a real integrator 1133, which integrates its input and dumps the sum under control of a control input 1134. The real integrator 1133 produces a real correlation signal 1135.

The imaginary product signal 1132 is coupled to an imaginary integrator 1136, which integrates its input and dumps the sum under control of a control input 1137. The imaginary integrator 1136 producers an imaginary correlation signal 1138.

The real correlation signal 1135 is coupled to a real squaring device 1139, which computes the square of its input. The imaginary correlation signals 1138 is coupled to an imaginary squaring devices 1140, which computes the square of its input. The two squared values are coupled to a summer 1141, which combines its inputs and produces a unified correlation signals 1142 which is the sum of the squares of the real correlation signal 1135 and the imaginary correlation signal 1136. The unified correlation signal 1142 is coupled to a square root device 1143, which takes the square root of its input and generates a final correlation signal 1144. The final correlation signal 1144 may have a maximum value once per symbol code time period Ts.

In a particular arrangement, a one-bit quantizor is inserted at the output of the first low pass filter 1113 and the second.low pass filter 1118.

In a preferred version of the Fig. 13A correlator, the real I multiplier 1121, imaginary Q multiplier 1123, imaginary I multiplier 1125, and real Q multiplier 1127 each comprise an inverted XOR gate. Inverted XOR gates are well known in the art; they have a truth table as shown in the table below:

| A | B | Inverted XOR (A,B) |
|----|----|-----|
| -1 | -1 | +1 |
| -1 | +1 | -1 |
| +1 | -1 | -1 |
| +1 | +1 | +1 |

In a preferred receiver , the real summer 1129 and real integrator 1133 collectively comprise a multiplexer and integrator. Instead of computing the individual real I and real Q components, summing them, and integrating the sum, in a preferred embodiment the individual real I and real Q components are multiplexed into a single stream and the stream itself integrated.

Likewise, the imaginary summer 1131 and imaginary integrator 1136 collectively comprise a multiplexer and integrator. Instead of computing the individual imaginary I and imaginary Q components, summing them, and integrating the sum, in a preferred embodiment the individual imaginary I and imaginary Q components are multiplexed into a single stream and the stream itself integrated.

In a preferred receiver , the first squaring device 1139, the second squaring device 1140, the summer 1141, and the square root device 1143 collectively comprise a device using the Robertson technique for computing the square root of the sum of two squares. In the Robertson technique, which is known in the art, the norm of a plane vector (the square root of the sum of two squares) having coordinates <x,y> may be approximated as follows:

$$\| \langle x,y \rangle \| = \text{maximum}(x,y) + (.5)\ \text{minimum}(x,y)$$

$$(1152)$$

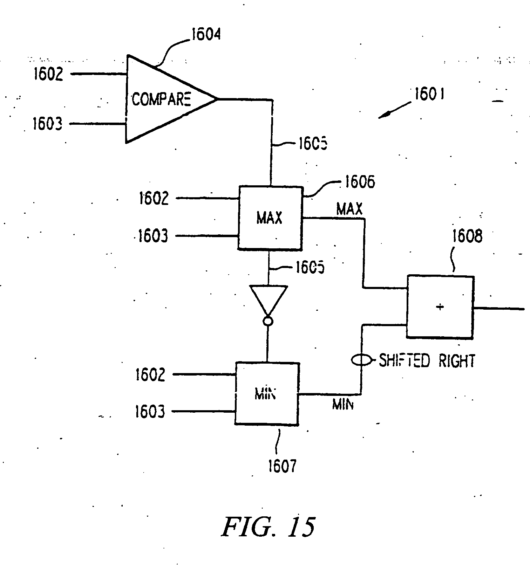

A preferred Robertson device is shown in Fig. 15 and is described later herein.

Figure 13B is a block diagram of a spread spectrum receiver using multi-bit serial correlation for separable real and imaginary parts of the received spread spectrum signal. The Fig. 13B receiver comprises a first power divider 1153 coupled to a received signal s*(t) 401, a local oscillator 1156, a second power divider 1158, multipliers 1161 and 1166, and low pass filters 1163 and 1168, all of which are similar to the Fig. 13A receiver. Also like the Fig. 13A receiver, the Q portion of the Real*(t) signal is the same as the I portion of the Imag*(t) signal, and the Q portion of the Imag*(t) signal is 180-degrees out of phase (i.e., the inverse) of the I portion of the Real*(t) signal.

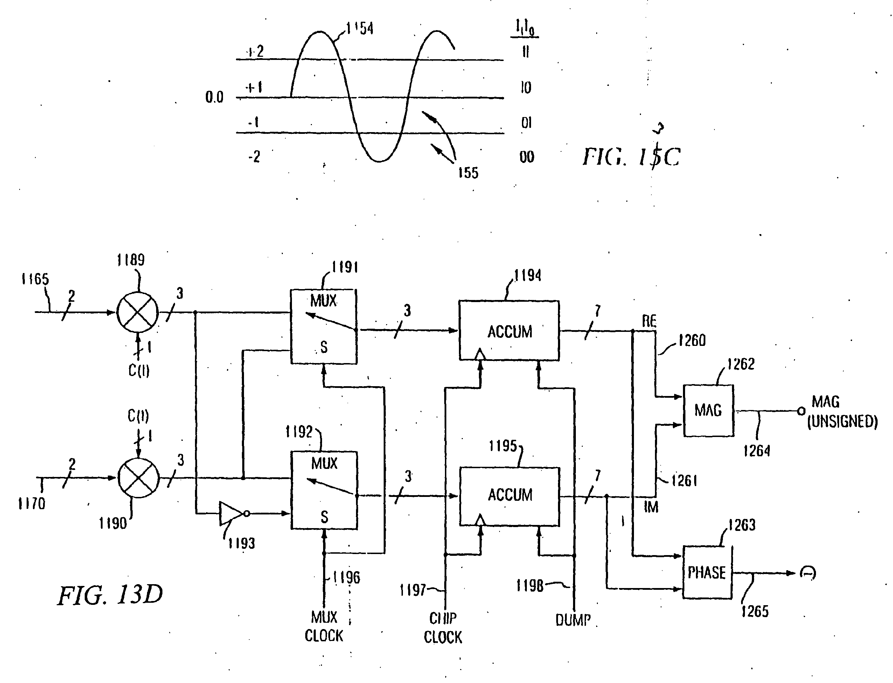

The low pass filter 1163 is coupled to a two-bit analog-to-digital (A/D) converter 1164, and the other low pass filters 1168 is coupled to another two-bit A/D converter 1169. The two-bit A/D converters 1164 and 1169 each quantize their respective input waveforms, and output a two-bit pattern corresponding to the amplitude of the input waveform. Figure 13C is a graph showing a two-bit quantization of an input waveform 1154. Four amplitude regions 1155 are depicted in the graph of Fig. 13C. When the input waveform 1154 (e.g., the output of low pass filter 1163 or 1168) is in the highest amplitude region 1155, the A/D converter 1164 or 1169 outputs a two-bit pattern $I_1I_0$ of 11. When the input waveform 1154 is in the next highest amplitude region 1155, the A/D converter 1164 or 1169 outputs a two-bit pattern $I_1I_0$ of 10. Likewise, in the next highest amplitude region 1155, the A/D converter 1164 or 1169 outputs a two-bit pattern $I_1I_0$ of 01, and in the lowest amplitude region 1155 the A/D converter 1164 or 1169 outputs a two-bit pattern $I_1I_0$ of 00.

The inputs of A/D converters 1164, 1169 are sampled once each chip period. The outputs 1165, 1170 of the A/D converters 1164, 1169 are provided to a multi-bit non-coherent serial correlation block 1167. The output 1165 of A/D converter 1164 is coupled to the input of a multiplier 1172, which has another input coupled to a locally generated i(n) chip signal, which, in a particular embodiment, generates a two's complement waveform corresponding to the tri-value return-to-zero waveform used in Fig. 13A. The output 1165 of A/D converter 1164 is also coupled to the input of a second multiplier 1174, which has another input coupled to a locally generated inverse q(n) chip signal, which is likewise a tri-valued signal represented in two's complement format. The output 1170 of A/D converter 1169 is coupled to the input of a multiplier 1171, which has another input coupled to the i (n) chip signal. The output 1170 of A/D converter 1169 is also coupled to the input cf another multiplier 1173, which has another input coupled to a q(n) chip signal.

Each of multipliers 1171, 1172, 1173 and 1174 is preferably embodied as a digital multiplier that multiplies its inputs and generates a result in two's-complement format. A preferred input and output truth table for each of multipliers 1171, 1172, 1173 and 1174 appears in Table 15-1 below, wherein $i_c$ and $q_c$ represent the chip value of the i(t) or q(t) signal at the appropriate time interval. A binary 0-bit for $i_c$ or $q_c$ represents a -1 chip value, while a binary 1-bit for $i_c$ or $q_c$ represents a +1 chip value. These values are, as noted for this particular embodiment, expressed in two's complement format for the signals i(n) and q(n).

Table 15-1

| A/D Output ($I_1$ $I_0$) | | I/Q Signal ($i_c$ or $q_c$) | Result ($O_2$ $O_1$ $O_0$) | | | Decimal Equivalent |
|---|---|---|---|---|---|---|
| 0 | 0 | 0 | 0 | 1 | 0 | +2 |
| 0 | 0 | 1 | 1 | 1 | 0 | -2 |
| 0 | 1 | 0 | 0 | 0 | 0 | +1 |
| 0 | 1 | 1 | 1 | 1 | 1 | -1 |
| 1 | 0 | 0 | 1 | 1 | 1 | -1 |
| 1 | 0 | 1 | 0 | 0 | 1 | +1 |
| 1 | 1 | 0 | 1 | 1 | 0 | -2 |
| 1 | 1 | 1 | 0 | 1 | 0 | +2 |

The output from each of multipliers 1171, 1172, 1173 and 1174 comprises a 3-bit digital signal according to Table 15-1. The outputs from multipliers 1171, 1172, 1173 and 1174 are coupled to accumulators 1175, 1176, 1177, and 1178, respectively. A chip clock signal 1181 is connected to each of the accumulators 1175, 1176, 1777 and 1178, and causes the accumulators 1175, 1176, 1177 and 1178 to sample their inputs once each chip period. Thus, for a symbol code length of 32 chips, the accumulators 1175, 1176, 1177 and 1178 sample their inputs 32 times for a given symbol code. At each sample time, the accumulators 1175, 1176, 1177 and 1178 add the input to a running correlation total. Because the outputs of A/D converters 1164 and 1169 are represented in two's-complement notation, the accumulators 1175, 1176, 1177 and 1178 effectively carry out addition or subtraction by performing only adding operations. A dump signal 1182 clears the accumulators at the end of each symbol period. For a 32 chip symbol code, the running accumulator totals will vary between +32 and -32.

Alternatively, instead of using the two's-complement formal signals i(n) and q(n), the tri-valued return-to-zero waveforms such as i (t) and q(t) (see Fig. :13A) may be used. In such a case, the accumulators 1175, 1176, 1177 and 1178 would each accumulate every other clock cycle in an alternating pattern, rather than every clock cycle.

Each accumulator 1175, 1176, 1177, and 1178 outputs a 6-bit digital accumulation value. The outputs of accumulators 1176 and 1177 are coupled to the inputs of a first summer 1179. The outputs of accumulators 1175 and 1180 are coupled to the inputs of a second summer 1180. Outputs of summers 1179 and 1180 are coupled to a magnitude calculation block 1185 and a phase calculation block 1187. The magnitude calculation block 1185 may be embodied as a Robertson device (see, e.g., Fig. 15). The phase calculation block 1187 may be embodied as, e.g., a phase sector lookup table.

The magnitude calculation block 1185 and phase calculation block 1187 output a unified correlation signal 1186 and a phase signal 1188, respectively. The unified correlation signal 1186 may be, e.g., a 7 -bit unsigned digital signal.

Experiment has shown that the correlator of Fig. 13B can realize an improvement in bit error rate (BER) and $E_b/N_o$ (bit energy/noise density) of approximately 1.5 to 2.0. dB over the correlator of Fig. 13A. While two-bit quantization leads to a significant improvement over single-bit quantization, it is expected that higher order quantization will yield increasingly smaller gains in BER and $E_b/N_o$ ratio up to a maximum aggregate improvement of about 3 dB. Thus, two-bit quantization provides an advantageous combination of improved performance without a large increase in hardware complexity.

Figure 13D is a block diagram of a portion of another embodiment of a spread spectrum receiver using multi-bit serial correlation for separable real and imaginary parts of the received spread spectrum signal. The circuitry shown in Fig: 13D corresponds to the multi-bit non-coherent serial correlation block 1167 depicted in Fig. 13B, but uses fewer components than the Fig. 13B arrangement.

In Fig. 13D., signal 1165 (see Fig. 13B) and a c(t) chip signals (i.e., a combined i(t) and q(t) signal) are coupled to inputs of a first multiplier 1189. Signal 1.170 (see Fig. 15B) and the c(t) chip signal are coupled to inputs of a second multiplier 1190. Multipliers 1189 and 1190 each carry out arithmetic operations according to Table 15-1. The output of the first multiplier 1189 is coupled to the input of a multiplexer 1191, and is coupled through an inverter 1193 to the input of another multiplexer 1192. The output of the second multiplier 1190 is coupled to an input of each of multiplexers 1191 and 1192.

A multiplexer clock signal 1196 controls the selection of inputs for each of multiplexers 1191 and 1192. Operation of multiplexer clock signal 1196 is based on the recognition that the i(t) and q(t) chip signals are staggered and will be zero every other chip time

The multiplexer clock signal 1196 causes the input of the multiplexers 1191, 1192 to switch so as to ignore the output from the multiplier 1189, 1190 that would be zero because the i(t) or q(t) portion of the c(t) chip signal is zero. Thus, the inputs to multiplexers 1191, 1192 are switched each chip time.

The output from multiplexer 1191 is input to an accumulator 1194. The output from multiplexer 1192 is input to another accumulator 1195. Accumulators 1194 and 1195 function similarly to accumulators 1175, 1176, 1177 or 1178 in Fig. 13B, by performing two's-complement accumulation of their inputs to keep a running correlation total. The accumulators 1194, 1195 are controlled by a chip clock signal 1197 and a dump signal 1198, similar to chip clock signal 1181 and dump signal 1182, respectively, of Fig. 13B.

The output 1260 of accumulator 1194 is coupled to a magnitude calculation block 1262 and a phase calculation block 1263. The output 1261 of accumulator 1195 is likewise coupled to magnitude calculation block 1262 and phase calculation block 1263. Magnitude calculation block 1262 is similar to magnitude calculation block 1185 of Fig. 13B; phase calculation block 1187 is likewise similar to phase calculation block 1187 of Fig. 13B. Magnitude calculation block 1262 and phase calculation block 1263 output a unified correlation signal 1264 and a phase signal 1265, respectively.

A method of receiving and despreading a spread spectrum signal using non-coherent multi-bit serial correlation is also provided. The method includes the steps of dividing a spread spectrum signal into first and second duplicate signals, demodulating the first signal into a real-I/imaginary-Q signal using a first non-coherent local reference signal, demodulating the second signal into an imaginary-I/real-Q signal using a second non-coherent local reference signal having the same frequency as said first non-coherent local reference signal but phase offset therefrom by 90 degrees, converting the real-I/ imaginary-Q. signal into a first multi-bit digital signal, converting the imaginary-I/real-Q signal into a second multi-bit digital signal, correlating the first multi-bit digital signal with a chip sequence comprising odd chips and even chips, accumulating a first correlation total, correlating the second multi-bit digital signal with the odd chips and an inverse of the even chips of the chip sequence, accumulating a second correlation total, and combining the first correlation total and the second- correlation total to generate a unified correlation output signal.

In one variation of the method, the steps of correlating said first multi-bit digital signal, accumulating a first correlation total, correlating said second multi-bit digital signal, accumulating a second correlation total, and combining said first correlation total and said second correlation total comprise the steps of multiplying the real-I/imaginary-Q signal with said odd chips to generate a real I product signal, multiplying the imaSinary-I/real-Q signal with said even chips to generates a real Q product signal, multiplying the imaginary-I/real-Q signal with said odd chips to generate an imaginary I product signal, multiplying the real-I/imaginary-Q signal with the inverse of said even chips to generate an imaginary Q product signal, individually accumulating at each chip period of said chip sequence the real I product signal, real Q product signal, imaginary I product signal, and imaginary Q product signal, summing the accumulated real I product signal and the accumulated real Q product signal into a real correlation signal, summing the accumulated imaginary product signal and the accumulated imaginary Q product signal into an imaginary correlation signal, and combining the real correlation signal and the imaginary correlation signal into a unified correlation signal.

In another variation of the method, the steps of correlating said first multi-bit digital signal, accumulating a first correlation total, correlating said second multi-bit digital signal, accumulating a second correlation total, and combining said first correlation total and said second correlation total comprise the steps of multiplying the real-I/imaginary-Q signal with the chip sequence c(t) to generate a real-I/imaginary-Q product signal, multiplying the imaginary-I/real-Q signal with the chip sequence c(t) to generate an imaginary-I/real-Q product signal, sampling and adding the real-I/imaginary-Q product signal into a first running correlation total (e.g., a real correlation total) the imaginary-I/real-Q product signal into a second running correlation total (e.g., an imaginary correlation total) for the odd chips of the chip sequence, and sampling and adding the imaginary-I/real-Q product signal into said first running correlation total an inverse of the real-I/imaginary-Q product signal into a second running correlation total for the even chips of the chip sequence.

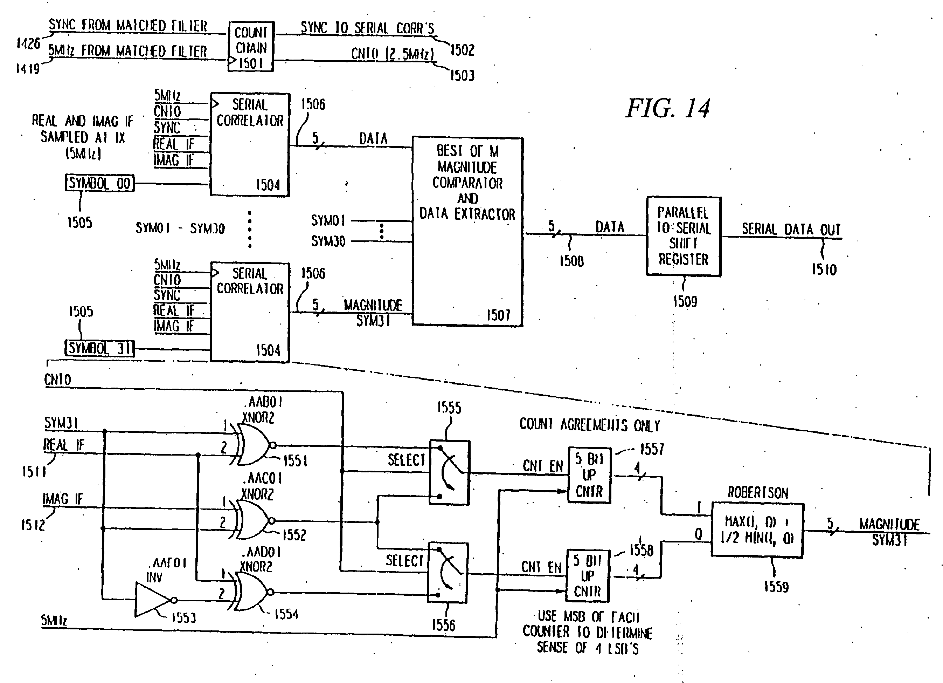

An exploded view of an individual serial correlator 1504 is also shown in Fig. 14. The serial correlator 1504. shown in the Fig. 14 arrangement operates in a conceptually similar manner to the dual-integrator non-coherent serial CPM correlator 1102 depicted in Fig. 13A. In an alternative preferred arrangement, the 32 serial correlators, operate according to the correlators embodiments described with respect to Fig. 13B or 13D. The real-I/imaginary-Q signal 1511 is coupled to XNOR gates 1551 and 1552, and the imaginary-I/real-Q signal 1512 is coupled to XNOR gate 1552. XNOR gates generate the inverted XOR of their inputs. The XNOR gates 1551 and 1552 perform the function of multipliers 1121, 1123, 1125 and 1127 depicted in Fig. 13A. Each serial correlator 1504 is programmed to correlate to a different symbol code; accordingly, the appropriate symbol code is clocked into the XNOR gates 1551, 1552 and 1554 from the symbol generator 1505. The symbol code is inverted by invertor 1553 before being received by XNOR gate 1554 because XNOR gate 1554 operates on the inverse of the q(t) signal.

Summation and integration is carried out by a pair of multiplexors 1555, 1556 and counters 1557, 1558. The outputs of the XNOR gates 1551 and 1552 are coupled to an real multiplexor 1555; the outputs of the XNOR gates 1552 and 1554 are coupled to an imaginary multiplexor 1556. The counter clock 1503 is coupled to a control input of the real multiplexor 1555 and the imaginary multiplexor 1556 in order to control the integrate-and-dump function. The outputs of the real multiplexor 1555 and the imaginary multiplexor 1556 are coupled to the enable inputs of the real counter 1557 and the imaginary counter 1558, respectively. Because the received I and Q signals are time staggered, the real multiplexor 1555 selects between real I and real Q signals and provides them to the real Counter 1557 to effectively sum and integrate the real I and real Q signals; the imaginary multiplexor 1556 and imaginary counter 1558 operate in an analogous manner with respect to imaginary I and imaginary Q signals.

A reset command may be provided to the real counter 1557 and the imaginary counter 1558 to perform an operation analogous to a "dump" as would be carried out with integrate-and-dump.circuits shown in Fig. 15A.

The output of the real counter 1557 and of the imaginary counter 1558 are coupled to a Robertson device 1559, which computes an approximation to the root of the sum of the squares of its inputs. An output of the Robertson device 1559 is output from the serial correlator 1504, and generally corresponds to the final correlation signal 1144 such as described with respect to Fig. 13A.

A serial correlator 1504 may be designed to operate with multi-bit resolution to improve correlation accuracy.

Figure 15 is a block diagram showing a preferred embodiment of a Robertson device 1601.

The Robertson device 1601 has an input 1602 and an input 1603, and computes an approximation of the square root of the sum of the squares of its inputs, as shown in equation 1152. The input 1602 and input 1603 may be binary inputs such as 5-bit binary numbers. The input 1602 and the input 1603 are coupled to a comparator 1604, which generates a control output 1605 indicating whether the input 1602 is greater than the input 1603..

The input 1602 and the input 1603 are also coupled to a selector 1606, which outputs the greater of the input 1602 and the input 1603 in response to the control output 1605.

The input 1602 and the input 1603 are also coupled to a selector 1607, which outputs the lesser of the input 1602 and the input 1603 in response to an inverse of the control outputs 1605.

The output of the selector 1606 and the output of the selector 1607 are coupled to an adder 1608. However, prior to being connected to the adder 1608, the output of the second selector 1607 is shifted right one bit, i.e., the 0. (least significant) bit of the output of the second selector 1607 may be discarded, the 1 (next least significant) bit of the output of the second selector 1607 may be transferred to the 0 (least significant) bit position, the 2 bit of the output of the second selector 1607 may be transferred to the 1 bit position, and so on. The right shift has the effect of dividing the output of the second selector 1607 by two (and dropping the least significant bit).

The output of the adder 1608 may be output from the Robertson device 1601, which therefore effectuates equation 1152 as set forth herein.

While preferred embodiments are disclosed herein, many variations are possible which remain within the concept and scope of the invention, and these variations would become clear to one of ordinary skill in the art after perusal of the specification, drawings and claims herein.

While information to be transmitted from transmitter to receiver is generally referred to herein as "data", the term "data" may comprise data, error-correcting codes, control information, protocol information, or other signals, and all these are deemed to be within the scope of the invention.

While the invention as shown in embodiments herein uses certain CPM encoding techniques, those skilled in the art would recognize, after perusal of this application, that a number of encoding methods, such as MSK, GMSK, SQAM, SQORC, and other known spread-spectrum techniques, would be workable and fall within the scope of the invention. The invention therefore is not to be restricted except within the scope of the appended claims.

**Claims**

1. A method of despreading a continuous phase modulated spread spectrum signal, the spread spectrum signal generated from a sequence of odd chips and even chips, the method comprising:

   receiving the spread spectrum signal (401);
   separating (803) the spread spectrum signal into first (804) and second (805) duplicate signals;
   demodulating (811) the first signal into a first demodulated signal (812) by multiplying the first signal by a first non-coherent local reference signal ($\cos\omega_1 t$); and
   demodulating (816) the second signal into a second demodulating signal (817) by multiplying the second signal by a second non-coherent local reference signal ($\sin\omega_1 t$), the second non-coherent local reference signal having the same frequency as the first non-coherent local reference signal but phase offset therefrom by 90 degrees;
   **characterised by**:
   temporarily storing the first demodulated signal in a single first register (821), and temporarily storing the second demodulated signal in a single second register (827), said single first register (821) and said single second register (827) each being capable of holding a sequence of chips (822);
   correlating the odd chips of the first register (821) with a first code to generate a first correlation signal (824) and correlating the even chips of the first register (821) with the first code to generate a second correlation signal (826);
   correlating the odd chips of the second register (827) with a second code to generate a third correlation signal (830) and correlating the even chips of the second register (827) with the second code to generate a fourth correlation signal (832);
   summing (833) the first and fourth correlation signals to obtain a fifth correlation signal (834);
   summing (835) the second and third correlation signals to obtain a sixth correlation signal (836); and
   summing the squares of the fifth and sixth correlation signals to obtain a unified correlation signal (834).

2. The method of claim 1:

   wherein demodulating the first signal comprises demodulating (811) the first signal into a real-I/imaginary-Q signal (812) and wherein temporarily storing the first demodulated signal comprises temporarily storing the real-I/imaginary-Q signal in a single first register (821);
   wherein demodulating the second signal comprises demodulating (816) the second signal into an imaginary-1/real-Q signal (817) and wherein temporarily storing the second demodulated signal comprises temporarily storing the imaginary-I/real-Q signal in a single second register (827);
   wherein correlating the contents of the first register comprises correlating the contents of the first register to generate a real I correlation signal (824) and an imaginary Q correlation signal (826); and
   wherein correlating the contents of the second register comprises correlating the contents of the second register to generate an imaginary I correlation signal (830) and a real correlation signal (832).

3. The method of claim 1:

   wherein correlating the contents of the first and the second registers comprises inputting the first signal into a first even/odd correlator (815), correlating the first signal in the first even/odd correlator to generate a Real I correlation signal (824) and an Imaginary Q correlation signal (826), inputting the second signal into a second even/odd correlator, correlating the second signal in the second even/odd correlator (827) to generate an Imaginary I correlation signal (830) and a Real Q correlation signal (832); and further comprising computing (841) a square root of the unified correlation signal.

4. The method of any one of claims 1, 2 or 3 wherein the odd chips and the even chips each correspond to a tri-valued return-to-zero waveform.

5. An apparatus for despreading a received continuous phase modulated spread spectrum signal (704) comprising:

   a power divider (803) for dividing a received spread spectrum signal (401) into a first signal (804) and a second signal (805);

means for demodulating the first signal (804) into a real-I/imaginary-Q signal (814), by multiplying the first signal by a first non-coherent local reference signal (809);

a first even/odd correlator (815) comprising a first register (821) for temporarily storing the real-I/imaginary-Q signal (814) and capable of holding a sequence of chips, the first even/odd correlator (815) being configured to correlate the odd chips of the first register (821) with a first code to generate a real I correlation signal (824) and correlate the even chips of the first register (821) with the first code to generate an imaginary Q correlation signal (826);

means for demodulating the second signal (805) into an imaginary-I/real-Q signal (819) by multiplying the second signal by a second non-coherent local reference signal (810) having the same frequency as the first non-coherent local reference signal but phase offset therefrom by 90 degrees;

a second even/odd correlator (820) comprising a second register (827) for temporarily storing the imaginary-I/real-Q signal (819) and capable of holding a sequence of chips, the second even/odd correlator (820) being configured to correlate the odd chips of the second register (827) with a second code to generate an imaginary I correlation signal (830) and correlate the even chips of the second register (827) with the second code to generate a real Q correlation signal (832);

means for summing (833) the real I and real Q correlation signals to obtain a real correlation signal (834);

means for summing (835) the imaginary Q and imaginary I correlation signals to obtain an imaginary correlation signal (836); and

means for summing the squares of the real and imaginary correlation signals to obtain a unified correlation signal (840).

6. The apparatus of claim 5, wherein the first even/odd correlator and the second even/odd correlator each comprise:

a register (821) having a plurality of chip locations for receiving an input signal;

a plurality of I multipliers for comparing alternating ones of the chip locations with the odd chips of a chip sequence and generating a plurality of I comparison signals;

an I summer (823) for combining the I comparison signals into an I correlation signal (824);

a plurality of Q multipliers for comparing alternating ones of the chip locations either with the even chips of the chip sequence for the second even/odd correlator or with the inverse of the even chips for the first even/odd correlator, and for generating a plurality of Q comparison signals; and

a Q summer (825) for combining the Q comparison signals into a Q correlation signal (826).

7. The apparatus of claim 5 or 6 further comprising
means (839, 840, 841) for generating a square root of the unified correlation signal.

8. The apparatus of claim 7, wherein the means for generating a square root further comprises a Robertson device.

9. The apparatus of claim 5, wherein the first and second serial correlators comprise:

a first inverted-XOR logic gate (1551) having as inputs the first signal (1511) and a chip sequence;

a second inverted-XOR logic gate (1512) having as inputs the second signal (1512) and the chip sequence;

a third inverted-XOR logic gate (1554) having as inputs the first signal (1511) and the chip sequence;

a first multiplexer (1555) receiving as inputs an output of the first inverted-XOR logic gate and an output of the second inverted-XOR gate;

a second multiplexer (1556) receiving as inputs an output of the second inverted-XOR gate and an output of the third inverted-XOR gate, the first and second multiplexers under control of a common clocking signal (1505);

a first counter (1557) receiving an output of the first multiplexer and outputting a first count signal; and

a second counter (1558) receiving an output of the second multiplexer and outputting a second count signal.

10. The apparatus of any one or more of claims 6 to 10 wherein the means for demodulating the first and second signals comprises:

a first multiplier (1161) having inputs coupled to the first signal and a first referenced signal $\sin\omega_1 t$,

a second multiplier (1166) having inputs coupled to the second signal and a phase-offset version of the first referenced signal $\cos\omega_1 t$,

a first filter (1163) connected to an output of the first multiplier;

a second filter (1168) connected to an output of the second multiplier;

a first multi-bit analog-to-digital converter (1164) connected to an output of the first filter;
a second multi-bit analog-to-digital convertor (1169) connected to an output of the second filter; and wherein the first and second serial correlators comprise a multi-bit serial correlator (1167) connected to an output (1165) from said first multi-bit analog-to-digital convertor and an output (1170) from said second multi-bit analog-to-digital convertor, said multi-bit serial correlator outputting a unified correlation signal (1186) in response theretor.

11. The apparatus of claim 10 wherein the multi-bit serial correlator comprises:

a third multiplier (1172) and a fourth multiplier (1174) each connected to an output of the first multi- bit analog-to-digital convertor (1164);
a fifth multiplier (1171) and a sixth multiplier (1173) each connected to an output of the second multi-bit analog-to-digital convertor (1168);
an odd chip signal coupled to an input of the third multiplier and to an input of the fifth multiplier;
an even chip signal coupled to an input of the sixth multipler;
an inverse of the even chip signal coupled to an input of the fourth multiplier;
a first accumulator (1176) connected to an output of the third multiplier;
a second accumulator (1178) connected to an output of the fourth multiplier;
a third accumulator (1175) connected to an output of the fifth multiplier;
a fourth accumulator (1177) connected to an output of the sixth multiplier;
a first summer (1179) connected to an output of the first accumulator and the fourth accumulator;
a second summer (1180) connected to an output of the second accumulator and the third accumulator; and
a magnitude calculation block (1185) having inputs connected to an output of the first summer and to an output of the second summer.

12. The apparatus of claim 11, wherein the magnitude calculation block (1185) comprises a Robertson device.

13. The apparatus of claim 10 wherein the multi-bit serial correlator (1167) comprises a phase calculation block (1187).

**Patentansprüche**

1. Verfahren zum Entspreizen eines stetig phasenmodulierten (CPM) Spreizspektrumsignals, wobei das Spreizspektrumsignal aus einer Sequenz von ungeraden Chips und geraden Chips generiert ist, wobei das Verfahren umfasst:

Empfangen des Spreizspektrumsignals (401);
Separieren (803) des Spreizspektrumsignals in erste (804) und zweite (805) Duplikatsignale;
Demodulieren (811) des ersten Signals in ein erstes demoduliertes Signal (812) durch Multiplizieren des ersten Signals mit einem ersten inkohärenten lokalen Referenzsignal ($\cos\omega_1 t$); und
Demodulieren (816) des zweiten Signals in ein zweites demoduliertes Signal (817) durch Multiplizieren des zweiten Signals mit einem zweiten inkohärenten lokalen Referenzsignal ($\sin\omega_1 t$), wobei das zweite inkohärente lokale Referenzsignal die gleiche Frequenz wie das erste inkohärente lokale Referenzsignal, aber einen Phasenversatz davon um 90 Grad hat; **gekennzeichnet durch**:
temporäres Speichern des ersten demodulierten Signals in einem einzelnen ersten Register (821), und temporäres Speichern des zweiten demodulierten Signals in einem einzelnen zweiten Register (827), wobei das einzelne erste Register (821) und das einzelne zweite Register (827) jeweils fähig sind, eine Sequenz von Chips (822) zu halten;
Korrelieren der ungeraden Chips des ersten Registers (821) mit einem ersten Code, um ein erstes Korrelationssignal (824) zu generieren, und Korrelieren der geraden Chips des ersten Registers (821) mit dem ersten Code, um ein zweites Korrelationssignal (826) zu generieren;
Korrelieren der ungeraden Chips des zweiten Registers (827) mit einem zweiten Code, um ein drittes Korrelationssignal (830) zu generieren, und Korrelieren der geraden Chips des zweiten Registers (827) mit dem zweiten Code, um ein viertes Korrelationssignal (832) zu generieren;
Aufsummieren (833) des ersten und vierten Korrelationssignals, um ein fünftes Korrelationssignal (834) zu erhalten;
Aufsummieren (835) des zweiten und dritten Korrelationssignals, um ein sechstes Korrelationssignal (836) zu erhalten; und
Aufsummieren der Quadrate des fünften und sechsten Korrelationssignals, um ein vereinigtes Korrelationssignal (834) zu erhalten.

2. Verfahren nach Anspruch 1,

   wobei das Demodulieren des ersten Signals ein Demodulieren (811) des ersten Signals in ein reales I-/imaginäres Q-Signal (812) umfasst und wobei das temporäre Speichern des ersten demodulierten Signals ein temporäres Speichern des realen I-/imaginären Q-Signals in einem einzelnen ersten Register (821) umfasst;
   wobei das Demodulieren des zweiten Signals ein Demodulieren (816) des zweiten Signals in ein imaginäres I-/reales Q-Signal (817) umfasst und wobei das temporäre Speichern des zweiten demodulierten Signals ein temporäres Speichern des imaginären I-/realen Q-Signals in einem einzelnen zweiten Register (827) umfasst;
   wobei das Korrelieren der Inhalte des ersten Registers ein Korrelieren der Inhalte des ersten Registers umfasst, um ein reales I-Korrelationssignal (824) und ein imaginäres Q-Korrelationssignal (826) zu generieren; und
   wobei das Korrelieren der Inhalte des zweiten Registers ein Korrelieren der Inhalte des zweiten Registers umfasst, um ein imaginäres I-Korrelationssignal (830) und ein reales Korrelationssignal (832) zu generieren.

3. Verfahren nach Anspruch 1,
   wobei das Korrelieren der Inhalte des ersten und des zweiten Registers umfasst: Eingeben des ersten Signals in einen ersten Gerade/Ungerade-Korrelator (815) umfasst, Korrelieren des ersten Signals in dem ersten Gerade/Ungerade-Korrelator, um ein reales I-Korrelationssignal (824) und ein imaginäres Q-Korrelationssignal (826) zu generieren, Eingeben des zweiten Signals in einen zweiten Gerade/Ungerade-Korrelator, Korrelieren des zweiten Signals in dem zweiten Gerade/Ungerade-Korrelator (827), um ein imaginäres I-Korrelationssignal (830) und ein reales Q-Korrelationssignal (832) zu generieren; und des Weiteren umfassend
   Berechnen (841) einer Quadratwurzel des vereinigten Korrelationssignals.

4. Verfahren nach einem der Ansprüche 1, 2 oder 3, wobei die ungeraden Chips und die geraden Chips jeweils zu einer dreiwertigen Rückkehr-zu-Null-Wellenform korrespondieren.

5. Vorrichtung zum Entspreizen eines empfangenen stetig phasenmodulierten (CPM) Spreizspektrumsignals (704), umfassend:

   einen Leistungsteiler (803) zum Teilen eines empfangenen Spreizspektrumsignals (401) in ein erstes Signal (804) und ein zweites Signal (805);
   eine Einrichtung zum Demodulieren des ersten Signals (804) in ein reales I-/imaginäres Q-Signal (814) durch Multiplizieren des ersten Signals mit einem ersten inkohärenten lokalen Referenzsignal (809);
   einen ersten Gerade/Ungerade-Korrelator (815), umfassend ein erstes Register (821) zum temporären Speichern des realen I-/imaginären Q-Signals (814) und geeignet zum Halten einer Sequenz von Chips, wobei der erste Gerade/Ungerade-Korrelator (815) konfiguriert ist, die ungeraden Chips des ersten Registers (821) mit einem ersten Code zu korrelieren, um ein reales I-Korrelationssignal (824) zu generieren, und die geraden Chips des ersten Registers (821) mit dem ersten Code zu korrelieren, um ein imaginäres Q-Korrelationssignal (826) zu generieren;
   eine Einrichtung zum Demodulieren des zweiten Signals (805) in ein imaginäres I-/reales Q-Signal (819) durch Multiplizieren des zweiten Signals mit einem zweiten inkohärenten lokalen Referenzsignal (810), welches die gleiche Frequenz wie das erste inkohärente lokale Referenzsignal, aber einen Phasenversatz davon um 90 Grad hat;
   einen zweiten Gerade/Ungerade-Korrelator (820), umfassend ein zweites Register (827) zum temporären Speichern des imaginären I-/realen Q-Signals (819) und geeignet zum Halten einer Sequenz von Chips, wobei der zweite Gerade/Ungerade-Korrelator (820) konfiguriert ist, die ungeraden Chips des zweiten Registers (827) mit einem zweiten Code zu korrelieren, um ein imaginäres I-Korrelationssignal (830) zu generieren, und die geraden Chips des zweiten Registers (827) mit dem zweiten Code zu korrelieren, um ein reales Q-Korrelationssignal (832) zu generieren;
   eine Einrichtung zum Aufsummieren (833) des realen I- und realen Q-Korrelationssignals, um ein reales Korrelationssignal (834) zu erhalten;
   eine Einrichtung zum Aufsummieren (835) des imaginären Q- und imaginären I-Korrelationssignals, um ein imaginäres Korrelationssignal (836) zu erhalten; und
   eine Einrichtung zum Aufsummieren der Quadrate des realen und imaginären Korrelationssignals, um ein vereinigtes Korrelationssignal (840) zu erhalten.

6. Vorrichtung nach Anspruch 5, wobei der erste Gerade/Ungerade-Korrelator und der zweite Gerade/Ungerade-Korrelator jeweils umfassen:

ein Register (821) mit einer Mehrzahl von Chipplätzen zum Empfangen eines Eingangssignals;
eine Mehrzahl von I-Multiplizierern zum Vergleichen von abwechselnden der Chipplätze mit den ungeraden Chips einer Chipsequenz und Generieren einer Mehrzahl von I-Vergleichssignalen;
einen I-Aufsummierer (823) zum Bündeln des I-Vergleichssignals in einem I-Korrelationssignal (824);
eine Mehrzahl von Q-Multiplizierern zum Vergleichen von abwechselnden der Chipplätze entweder mit den geraden Chips der Chipsequenz für den zweiten Gerade/Ungerade-Korrelator oder mit dem Inversen der geraden Chips für den ersten Gerade/Ungerade-Korrelator und zum Generieren einer Mehrzahl von Q-Vergleichssignalen; und
einen Q-Aufsummierer (825) zum Bündeln des Q-Vergleichssignals in einem Q-Korrelationssignal (826).

7. Vorrichtung nach Anspruch 5 oder 6, weiter umfassend
eine Einrichtung (839, 840, 841) zum Generieren einer Quadratwurzel des vereinigten Korrelationssignals.

8. Vorrichtung nach Anspruch 7, wobei die Einrichtung zum Generieren einer Quadratwurzel des Weiteren eine Robertson-Einrichtung umfasst.

9. Vorrichtung nach Anspruch 5, wobei der erste und zweite serielle Korrelator umfassen:

ein erstes invertiertes XOR-Logikgatter (1551), welches als Eingaben das erste Signal (1511) und eine Chipsequenz hat;
ein zweites invertiertes XOR-Logikgatter (1512), welches als Eingaben das zweite Signal (1512) und die Chipsequenz hat;
ein drittes invertiertes XOR-Logikgatter (1554), welches als Eingaben das erste Signal (1511) und die Chipsequenz hat;
einen ersten Multiplexer (1555), welcher als Eingaben eine Ausgabe des ersten invertierten XOR-Logikgatters und eine Ausgabe des zweiten invertierten XOR-Gatters empfängt;
einen zweiten Multiplexer (1556), welcher als Eingaben eine Ausgabe des zweiten invertierten XOR-Gatters und eine Ausgabe des dritten invertierten XOR-Gatters empfängt, wobei der erste und zweite Multiplexer unter der Steuerung eines gemeinsamen Taktsignals (1505) stehen;
einen ersten Zähler (1557), welcher eine Ausgabe des ersten Multiplexers empfängt und ein erstes Zählsignal ausgibt; und
einen zweiten Zähler (1558), welcher eine Ausgabe des zweiten Multiplexers empfängt und ein zweites Zählsignal ausgibt.

10. Vorrichtung nach einem oder mehreren der Ansprüche 6 bis 10, wobei die Einrichtung zum Demodulieren des ersten und zweiten Signals umfasst:

einen ersten Multiplizierer (1161) mit Eingängen, welche an das erste Signal und ein erstes referenziertes Signal $\sin\omega_1 t$ gekoppelt sind,
einen zweiten Multiplizierer (1166) mit Eingängen, welche an das zweite Signal und eine phasenverschobene Version des ersten referenzierten Signals $\cos\omega_1 t$ gekoppelt sind,
einen ersten Filter (1163), welcher mit einem Ausgang des ersten Multiplizierers verbunden ist;
einen zweiten Filter (1168), welcher mit einem Ausgang des zweiten Multiplizierers verbunden ist;
einen ersten Multi-Bit-Analog-Digital-Konverter (1164), welcher mit einem Ausgang des ersten Filters verbunden ist;
einen zweiten Multi-Bit-Analog-Digital-Konverter (1169), welcher mit einem Ausgang des zweiten Filters verbunden ist; und
wobei der erste und zweite serielle Korrelator einen Multi-Bit seriellen Korrelator (1167) umfassen, welcher mit einem Ausgang (1165) von dem ersten Multi-Bit-Analog-Digital-Konverter und einem Ausgang (1170) von dem zweiten Multi-Bit-Analog-Digital-Konverter verbunden ist, wobei der Multi-Bit serielle Korrelator als Antwort darauf ein vereinigtes Korrelationssignal (1186) ausgibt.

11. Vorrichtung nach Anspruch 10, wobei der Multi-Bit serielle Korrelator umfasst:

einen dritten Multiplizierer (1172) und einen vierten Multiplizierer (1174), welche jeweils mit einem Ausgang des ersten Multi-Bit-Analog-Digital-Konverters (1164) verbunden sind;
einen fünften Multiplizierer (1171) und einen sechsten Multiplizierer (1173), welche jeweils mit einem Ausgang des zweiten Multi-Bit-Analog-Digital-Konverters (1168) verbunden sind;

ein ungerades Chipsignal, welches an einen Eingang des dritten Multiplizierers und an einen Eingang des fünften Multiplizierers gekoppelt ist;

ein gerades Chipsignal, welches an einen Eingang des sechsten Multiplizierers gekoppelt ist;

ein Inverses des geraden Chipsignals, welches an einen Eingang des vierten Multiplizierers gekoppelt ist;

einen ersten Speicher (1176), welcher mit einem Ausgang des dritten Multiplizierers verbunden ist;

einen zweiten Speicher (1178), welcher mit einem Ausgang des vierten Multiplizierers verbunden ist;

einen dritten Speicher (1175), welcher mit einem Ausgang des fünften Multiplizierers verbunden ist;

einen vierten Speicher (1177), welcher mit einem Ausgang des sechsten Multiplizierers verbunden ist;

einen ersten Aufsummierer (1179), welcher mit einem Ausgang des ersten Speichers und des vierten Speichers verbunden ist;

einen zweiten Aufsummierer (1180), welcher mit einem Ausgang des zweiten Speichers und des dritten Speichers verbunden ist; und

einen Größenberechnungsblock (1185) mit Eingängen, welche mit einem Ausgang des ersten Aufsummierers und einem Ausgang des zweiten Aufsummierers verbunden sind.

**12.** Vorrichtung nach Anspruch 11, wobei der Größenberechnungsblock (1185) eine Robertson-Einrichtung umfasst.

**13.** Vorrichtung nach Anspruch 10, wobei der Multi-Bit serielle Korrelator (1167) einen Phasenberechnungsblock (1187) umfasst.

**Revendications**

**1.** Procédé de désétalement d'un signal à spectre étalé modulé en phase continue, le signal à spectre étalé étant généré à partir d'une séquence de puces impaires et de puces paires, le procédé comprenant les étapes ci-après consistant à :

recevoir le signal à spectre étalé (401) ;

séparer (803) le signal à spectre étalé en des premier (804) et deuxième (805) signaux dupliqués ;

démoduler (811) le premier signal en un premier signal démodulé (812) en multipliant le premier signal par un premier signal de référence local non cohérent ($\cos\omega_i t$) ; et

démoduler (816) le deuxième signal en un deuxième signal de démodulation (817) en multipliant le deuxième signal par un deuxième signal de référence local non cohérent ($\sin\omega_i t$), le deuxième signal de référence local non cohérent ayant la même fréquence que le premier signal de référence local non cohérent, mais étant décalé en phase de 90 degrés par rapport à celui-ci ; **caractérisé par** les étapes ci-après consistant à :

stocker temporairement le premier signal démodulé dans un premier registre unique (821), et stocker temporairement le deuxième signal démodulé dans un second registre unique (827), ledit premier registre unique (821) et ledit second registre unique (827), étant chacun aptes à conserver une séquence de puces (822) ;

corréler les puces impaires du premier registre (821) avec un premier code pour générer un premier signal de corrélation (824) et corréler les puces paires du premier registre (821) avec le premier code pour générer un deuxième signal de corrélation (826) ;

corréler les puces impaires du second registre (827) avec un second code pour générer un troisième signal de corrélation (830) et corréler les puces paires du second registre (827) avec le second code pour générer un quatrième signal de corrélation (832) ;

additionner (833) les premier et quatrième signaux de corrélation pour obtenir un cinquième signal de corrélation (834) ;

additionner (835) les deuxième et troisième signaux de corrélations pour obtenir un sixième signal de corrélation (836) ; et

additionner les carrés des cinquième et sixième signaux de corrélation pour obtenir un signal de corrélation unifié (834).

**2.** Procédé selon la revendication 1 :

dans lequel l'étape consistant à démoduler le premier signal comprend l'étape consistant à démoduler (811) le premier signal en un signal réel I / imaginaire Q (812) et dans lequel l'étape consistant à stocker temporairement le premier signal démodulé comprend l'étape consistant à stocker temporairement le signal réel I / imaginaire Q dans un premier registre unique (821) ;

dans lequel l'étape consistant à démoduler le deuxième signal comprend l'étape consistant à démoduler (816)

EP 1 420 520 B1

le deuxième signal en un signal imaginaire I / réel Q (817) et dans lequel l'étape consistant à stocker temporairement le deuxième signal démodulé comprend l'étape consistant à stocker temporairement le signal imaginaire I / réel Q dans un second registre unique (827) ;

dans lequel l'étape consistant à corréler le contenu du premier registre comprend l'étape consistant à corréler le contenu du premier registre en vue de générer un signal de corrélation réel I (824) et un signal de corrélation imaginaire Q (826) ; et

dans lequel l'étape consistant à corréler le contenu du second registre comprend l'étape consistant à corréler le contenu du second registre en vue de générer un signal de corrélation imaginaire I (830) et un signal de corrélation réel (832).

3. Procédé selon la revendication 1 :

dans lequel l'étape consistant à corréler le contenu des premier et second registres comprend l'étape consistant à introduire le premier signal dans un premier corrélateur pair / impair (815), l'étape consistant à corréler le premier signal dans le premier corrélateur pair / impair pour générer un signal de corrélation réel I (824) et un signal de corrélation imaginaire Q (826), l'étape consistant à introduire le deuxième signal dans un second corrélateur pair / impair, l'étape consistant à corréler le deuxième signal dans le second corrélateur pair / impair (827) pour générer un signal de corrélation imaginaire I (830) et un signal de corrélation réel Q (832), et comprenant en outre l'étape consistant à :

calculer (841) une racine carrée du signal de corrélation unifié.

4. Procédé selon l'une des revendications 1, 2 ou 3 dans lequel les puces impaires et les puces paires correspondent chacune à une forme d'onde avec retour à zéro de trois valeurs.

5. Dispositif pour désétaler un signal à spectre étalé modulé en phase continue reçu (704) comprenant :

un diviseur de puissance (803) permettant de diviser un signal à spectre étalé reçu (401) en un premier signal (804) et un deuxième signal (805) ;

des moyens pour démoduler le premier signal (804) en un signal réel I / imaginaire Q (814), en multipliant le premier signal par un premier signal de référence local non cohérent (809) ;

un premier corrélateur pair / impair (815) comprenant un premier registre (821) pour stocker temporairement le signal réel I / imaginaire Q (814) et apte à conserver une séquence de puces, le premier corrélateur pair / impair (815) étant configuré pour corréler les puces impaires du premier registre (821) avec un premier code pour générer un signal de corrélation réel I (824) et pour corréler les puces paires du premier registre (821) avec le premier code pour générer un signal de corrélation imaginaire Q (826) ;

des moyens pour démoduler le deuxième signal (805) en un signal imaginaire I / réel Q (819) en multipliant le deuxième signal par un deuxième signal de référence local non cohérent (810) ayant la même fréquence que le premier signal de référence local non cohérent, mais décalé en phase de 90 degrés par rapport à celui-ci ;

un second corrélateur pair / impair (820) comprenant un second registre (827) pour stocker temporairement le signal imaginaire I / réel Q (819) et apte à conserver une séquence de puces, le second corrélateur pair / impair (820) étant configuré pour corréler les puces impaires du second registre (827) avec un second code pour générer un signal de corrélation imaginaire I (830) et pour corréler les puces paires du second registre (827) avec le second code pour générer un signal de corrélation réel Q (832) ;

des moyens pour additionner (833) les signaux de corrélation réels Q et réels I pour obtenir un signal de corrélation réel (834) ;

des moyens pour additionner (835) les signaux de corrélation imaginaires Q et imaginaires I pour obtenir un signal de corrélation imaginaire (836) ; et

des moyens pour additionner les carrés des signaux de corrélation imaginaires et réels pour obtenir un signal de corrélation unifié (840).

6. Dispositif selon la revendication 5, dans lequel le premier corrélateur pair / impair et le second corrélateur pair / impair comprennent chacun :

un registre (821) présentant une pluralité d'emplacements de puces pour recevoir un signal d'entrée ;

une pluralité de multiplicateurs I pour comparer des emplacements alternatifs des emplacements de puces aux puces impaires d'une séquence de puces et générer une pluralité de signaux de comparaison I ;

un additionneur I (823) pour combiner les signaux de comparaison I en un signal de corrélation I (824) ;

une pluralité de multiplicateurs Q pour comparer des emplacements alternatifs des emplacements de puces

EP 1 420 520 B1

aux puces paires de la séquence de puces du second corrélateur pair / impair ou à l'inverse des puces paires du premier corrélateur pair / impair, et pour générer une pluralité de signaux de comparaison Q ; et
un additionneur Q (825) pour combiner les signaux de comparaison Q en un signal de corrélation Q (826).

7. Dispositif selon la revendication 5 ou 6, comprenant en outre
des moyens (839, 840, 841) pour générer une racine carrée du signal de corrélation unifié.

8. Dispositif selon la revendication 7, dans lequel les moyens pour générer une racine carrée comportent en outre un dispositif de Robertson.

9. Dispositif selon la revendication 5, dans lequel les premier et second corrélateurs en série comportent :

une première porte logique « OU exclusif » inversée (1551) présentant en tant qu'entrées le premier signal (1511) et une séquence de puces ;
une deuxième porte logique « OU exclusif » inversée (1512) présentant en tant qu'entrées le deuxième signal (1512) et la séquence de puces ;
une troisième porte logique « OU exclusif » inversée (1554) présentant en tant qu'entrées le premier signal (1511) et la séquence de puces ;
un premier multiplexeur (1555) recevant en tant qu'entrées une sortie de la première porte logique « OU exclusif » inversée et une sortie de la deuxième porte logique « OU exclusif » inversée ;
un second multiplexeur (1556) recevant en tant qu'entrées une sortie de la deuxième porte logique « OU exclusif » inversée et une sortie de la troisième porte logique « OU exclusif » inversée, les premier et second multiplexeurs étant commandés par un signal d'horloge commun (1505) ;
un premier compteur (1557) recevant une sortie du premier multiplexeur et générant en sortie un premier signal de comptage ; et
un second compteur (1558) recevant une sortie du second multiplexeur et générant en sortie un deuxième signal de comptage.

10. Dispositif selon l'une quelconque ou plusieurs des revendications 6 à 10, dans lequel les moyens permettant de démoduler les premier et second signaux comportent :

un premier multiplicateur (1161) présentant des entrées couplées au premier signal et à un premier signal référencé $\sin\omega_i t$,
un deuxième multiplicateur (1166) présentant des entrées couplées au deuxième signal et à une version décalée en phase du premier signal référencé $\cos\omega_i t$,
un premier filtre (1163) connecté à une sortie du premier multiplicateur ;
un second filtre (1168) connecté à une sortie du deuxième multiplicateur ;
un premier convertisseur analogique à numérique multi-bits (1164) connecté à une sortie du premier filtre ;
un second convertisseur analogique à numérique multi-bits (1169) connecté à une sortie du second filtre ; et
dans lequel les premier et second corrélateurs en série comportent un corrélateur en série multi-bits (1167) connecté à une sortie (1165) dudit premier convertisseur analogique à numérique multi-bits et à une sortie (1170) dudit second convertisseur analogique à numérique multi-bits, ledit corrélateur en série multi-bits générant en sortie un signal de corrélation unifié (1186) en réponse à cela.

11. Dispositif selon la revendication 10, dans lequel le corrélateur en série multi-bits comprend :

un troisième multiplicateur (1172) et un quatrième multiplicateur (1174) chacun connecté à une sortie du premier convertisseur analogique à numérique multi-bits (1164) ;
un cinquième multiplicateur (1171) et une sixième multiplicateur (1173) chacun connecté à une sortie du second convertisseur analogique à numérique multi-bits (1168) ;
un signal de puce impaire couplé à une entrée du troisième multiplicateur et à une entrée du cinquième multiplicateur ;
un signal de puce paire couplé à une entrée du sixième multiplicateur ;
un signal inverse du signal de puce paire couplé à une entrée du quatrième multiplicateur,
un premier accumulateur (1176) connecté à une sortie du troisième multiplicateur ;
un deuxième accumulateur (1178) connecté à une sortie du quatrième multiplicateur ;
un troisième accumulateur (1175) connecté à une sortie du cinquième multiplicateur ;
un quatrième accumulateur (1177) connecté à une sortie du sixième multiplicateur ;

26

un premier additionneur (1179) connecté à une sortie du premier accumulateur et du quatrième accumulateur ;

un second additionneur (1180) connecté à une sortie du deuxième accumulateur et du troisième accumulateur ;

un bloc de calcul d'amplitude (1185) présentant des entrées connectées à une sortie du premier additionneur et à une sortie du second additionneur.

**12.** Dispositif selon la revendication 11, dans lequel le bloc de calcul d'amplitude (1185) comprend un dispositif de Robertson.

**13.** Dispositif selon la revendication 10, dans lequel le corrélateur en série multi-bits (1167) comprend un bloc de calcul de phase (1187).

*FIG. 1*
(*PRIOR ART*)

*FIG. 2*

*FIG. 3*

FIG. 4A

FIG. 4B

FIG. 4C

Cos $\omega_0 t$

i(t)

250

q(t)

251

$\Sigma$

252

S(t)

FIG. 5A
(Prior Art)

Sin $\omega_0 t$

Q

265

260

268

266

I

267

FIG. 5B

y

y*

611

$\Delta\omega$

x*

604

612

$\theta$

X

601

610

607

613

FIG. 9

FIG. 6

FIG. 7

*FIG. 8*

FIG. 10

*FIG. 11A*

*FIG. 11B*

*FIG. 11C*

*FIG. 11D*

*FIG. 11E*

*FIG. 11F*

FIG. 12

*FIG. 13A*

*FIG. 13B*

FIG. 13C

FIG. 13D

EP 1 420 520 B1

*FIG. 14*

*FIG. 15*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5151920 A
- EP 0366086 A
- US 5402413 A

- US 5016255 A
- US 5022047 A

### Non-patent literature cited in the description

- **A. Baier ; P.W. Baier.** Digital Matched Filtering of Arbitrary Spread-Spectrum Waveforms Using Correlators with Binary Quantization. *2 Proceedings, 1983 IEEE Military Communications Conference,* 1983, vol. 2, 418-423
- **A. Baier.** A Low-Cost Digital Matched Filter for Arbitrary Constant-Envelope Spread Spectrum Waveforms. *IEEE Transactions on Communications,* April 1984, vol. Com-32 (4), 354-361
- **R. Dixon.** Spread Spectrum Systems with Commercial Applications. J. Wiley & Sons, 1994
- **Frank Amoroso ; James A. Kivett.** Simplified MSK Signaling Technique. *IEEE Transactions on Communications,* April 1977, 433-441

- **Mark C. Austin ; Ming U. Chang.** Quadrature Overlapped Raised-Cosine Modulation. *IEEE Transactions on Communications,* March 1981, vol. Com-29 (3), 237-249
- **Kazuaki Murota ; Kenkichi Hirade.** GMSK Modulation for Digital Mobile Radio Telephony. *IEEE Transactions on Communications,* July 1981, vol. Com-29 (7), 1044-1050
- **J.S. Seo ; K. Feher.** SQAM: A New Superposed QAM Modem Technique. *IEEE Transactions on Communications,* March 1985, vol. Com-33, 296-300